# EUROPÄISCHE PATENTSCHRIFT

(11) **EP 0 491 998 B1**
(45) Veröffentlichungstag und Bekanntmachung des Hinweises auf die Patenterteilung: **24.07.1996**
(21) Anmeldenummer: 90125728.7
(22) Anmeldetag: 28.12.1990
(51) Int. Cl.: G06F 11/26

(54) **Programmgesteuertes Verfahren und Anordnung zur Erzeugung von Impulsen in aufeinanderfolgenden Impulsintervallen**
Programme-controlled method and circuit arrangement for generating pulses within successive time intervals
Procédé commandé par programme et agencement pour la génération d'impulsions dans les intervalles de temps successifs

(43) Veröffentlichungstag der Anmeldung: 01.07.1992
(73) Patentinhaber: International Business Machines Corporation, Armonk, N.Y. 10504 (US)
(72) Erfinder: Staiger, Dieter Ernst, W-7039 Weil im Schönbuch (DE)
(74) Vertreter: Lindner-Vogt, Karin, Dipl.-Phys.

(56) Entgegenhaltungen:
- EP-A- 0 042 961
- EP-A- 0 128 228
- DE-A- 2 746 743
- DE-A- 2 829 709
- US-A- 4 806 852
- US-A- 4 928 278
- ELEKTRONIK, Band 37, Nr. 6, 18. März 1988, Ss. 94-97,100-102, München, DE; D. TANK et al.: "Mit dem "Turbo" schnell getestet"
- IBM JOURNAL OF RESEARCH AND DEVELOPMENT, Band 34, Nr. 2/3, März/Mai 1990, SS. 260-275, Armonk, N.Y., US; C.W. RODRIGUEZ et al.: "The development of ultra-high frequency VLSI device test systems"

## Beschreibung

Die Erfindung betrifft ein programmgesteuertes Verfahren und eine Anordnung zur Erzeugung von Impulsen vorgegebener Zeitrelation innerhalb vorgegebener Impulsintervalle mit sehr hoher zeitlicher Auflösung.

Impulsfolgen dieser Art sind für Computersteuerungen wie für die Adressierung von Haupt- oder Pufferspeichern insbesondere aber zum Austesten von Speicherprodukten (Speicher mit zugehörigen Pufferspeichern), von Digitalschaltungen u. a. m. erforderlich.

Beim Austesten von Speicherprodukten wird diesen ein entsprechendes Impulsmuster zugeführt. Das Verhalten des Speicherproduktes hinsichtlich dieses Impulsmusters wird aufgezeichnet und mit (theoretischen) Sollwerten verglichen. Der Vergleich beider Größen ermöglicht eine Aussage, ob das Speicherprodukt wie gewünscht arbeitet oder ob an bestimmten Stellen Fehler vorliegen.

Die zu erzeugende Impulsfolge ist durch die Spezifikationen des Speicherproduktes vorgegeben. Ausgehend von diesen (theoretischen) Werten muß die Impulsfolge dann praktisch von einem entsprechenden Impulsgenerator erzeugt werden.

Zur näheren Erklärung sei bemerkt, daß für ein möglichst optimales Austesten auch der Fall zu berücksichtigen ist, daß bei einem von der Produktseite her bestimmten Ereignis eine Impulsfolge von einer anderen abgelöst werden muß. D. h., die ursprüngliche Impulsfolge ist durch eine neue Impulsfolge beim Auftreten eines solchen Ereignisses zu ersetzen.

Bisher waren der zeitlichen Auflösung und Genauigkeit solcher Impulsfolgen durch die verfügbaren Schaltungen zu ihrer Erzeugung und durch die verfügbare Schaltkreistechnologie und der damit verbundenen Schnelligkeit der Schaltkreise Grenzen gesetzt.

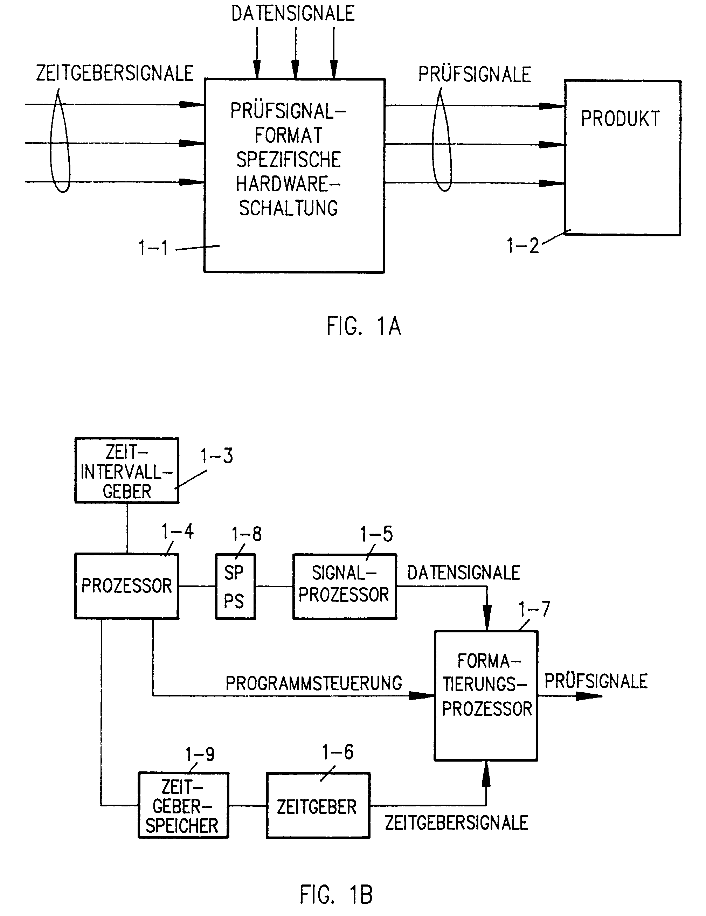

In Fig. 1A ist ein schematisches vereinfachtes Blockschaltbild zur Erzeugung von Prüfsignalen nach dem Stand der Technik gezeigt.

Wie aus Fig. 1A zu ersehen ist, werden die Prüfsignale von einer Prüfsignal-formatspezifischen Hardwareschaltung 1-1 aus Datensignalen und Zeitgebersignalen erzeugt. Mit diesen Prüfsignalen wird das auszutestende Produkt 1-2 beaufschlagt.

Diese Prüfsignale können unterschiedlicher Art sein; das auszutestende Produkt wird über verschiedene Leitungen mit diesen Prüfsignalen beaufschlagt. Beim Austesten von Speichern sind z.B. folgende Prüfsignalleitungen vorzusehen:

### Adreßleitungen;

Schreib(Write)leitungen, über die das Einschreiben von Information in adressierte Stellen des Speichers bewirkt wird;
Lese(Read)leitungen, über die das Auslesen von Information aus adressierten Stellen des Speichers bewirkt wird;
Datenleitungen für das Einschreiben von Information (DATA IN), auf denen die an adressierten Stellen des Speichers einzuschreibende Information vorgegeben wird;
Datenleitungen für das Auslesen von Information (DATA OUT), auf denen die an adressierten Stellen des Speichers auszulesende Information erscheint.

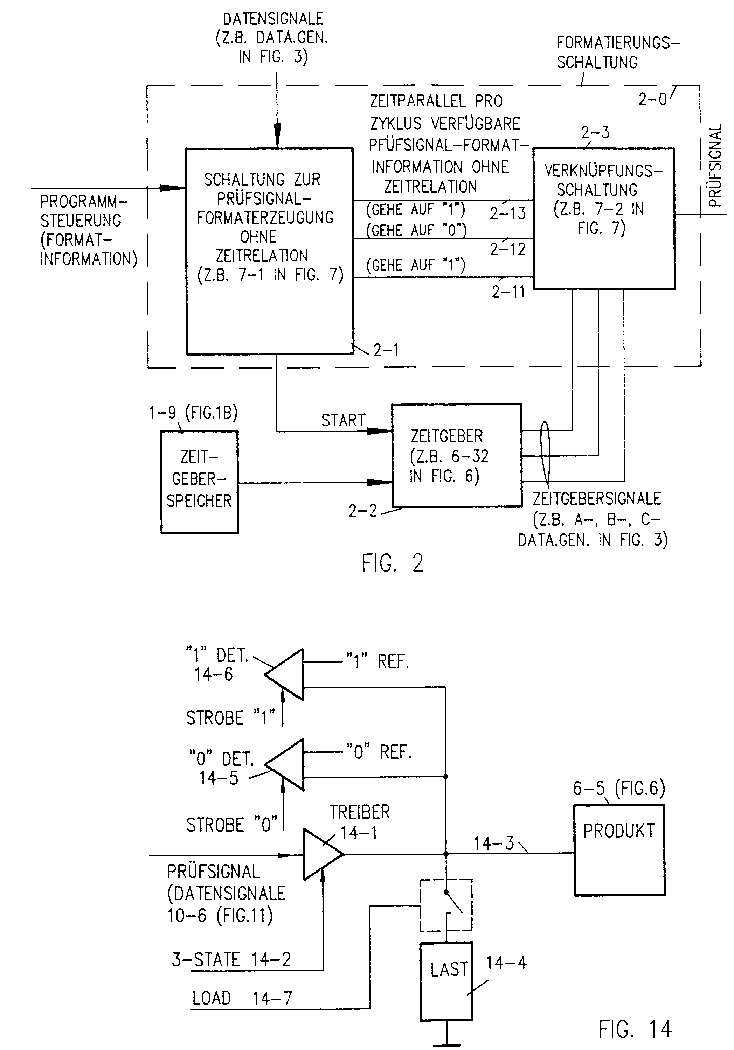

Fig. 1B zeigt ein schematisches Blockschaltbild eines Testsystemes nach dem Stand der Technik unter Berücksichtigung der Erzeugung der Daten- und Zeitgebersignale. Dieses Testsystem dient der Erzeugung von Prüfsignalmustern. Es umfaßt einen Zeitintervallgeber 1-3, welcher mit einem Prozessor 1-4 verbunden ist. Dieser Prozessor stellt die Daten zur Verfügung, welche zur Generierung der Datensignale im Signal-Prozessor 1-5, zur Generierung der Zeitgebersignale im Zeitgeber 1-6 und zur Programmsteuerung der Formatierungsschaltung 1-7 (s. auch Fig. 2) erforderlich sind. Dem Signal-Prozessor 1-5 ist ein Signal-Prozessor-Programmspeicher SPPS 1-8 vorgeschaltet; er enthält die Befehlscodes für den Signal-Prozessor 1-5. Dem Zeitgeber 1-6 ist ein Zeitgeberspeicher 1-9 vorgeschaltet; dieser enthält Zeitwerte für die Zeitgebersignale im Zeitintervall. Die Formatierungsschaltung dient der Verknüpfung der Datensignale mit den Zeitgebersignalen und beaufschlagt die Datensignale mit den Prüfsignalformaten. Ausführungen des Zeitsignalgebers 1-3 und des Prozessors 1-4 sind in der Deutschen Patentschrift DE 2746743 (Aktenzeichen der Anmelderin GE 977 024) und in der Deutschen Patentschrift DE 2829709 (Aktenzeichen der Anmelderin GE 978 014) beschrieben. (Der Gegenstand der letztgenannten Patentschrift stellt eine Verbesserung des Gegenstandes der erstgenannten Patentschrift dar.

Ausführungen des Zeitgebers 1-6 sind in der Europäischen Patentschrift 0042961 (Aktenzeichen der Anmelderin GE 979 042) und in der Europäischen Patentschrift 0128228 (Aktenzeichen der Anmelderin GE 983 012) beschrieben. (Der Gegenstand der letztgenannten Patentschrift stellt eine Verbesserung des Gegenstandes der vorgenannten Patentschrift dar.)

Der Signalprozessor kann nach dem Stand der Technik z.B. im einfachen Fall einer Adreßgenerierung ein binärer Synchron-Zähler oder im Fall eines komplexeren Datensignalverlaufes eine arithmetische Logik-Schaltung sein. Mit anderen Worten, um z.B. von einer Adresse xx nach yy zu gelangen, kann entweder binär aufwärts bzw. abwärts gezählt werden oder unter Vermeidung redundanter Zählvorgänge durch einen logischen Adreßsprung erreicht werden.

Formatierungsschaltungen (1-7) nach dem Stand der Technik weisen den wesentlichen Nachteil einer nicht in vertretbarem Maß kompensierbaren Zeitungenauigkeit auf. Die immer kürzer werdenden Zykluszeiten bei auszutestenden Produkten erfordern immer "schnellere" Testsysteme. Jedoch können diese Testsysteme auch mit durch die fortschreitende Technologie bedingten "schnelleren" Bauteilen nicht die geforderte Genauigkeit erreichen. Bestimmte schaltungsbedingte unverzichtbare Bauteile/Baugruppen in bekannten Testsystemen weisen unterschiedliche Signalstrecken mit unterschiedlichen Signallaufzeiten auf, welche die zeitliche Ungenauigkeit des Testsystemes bedingen.

(Beispiel: In intern verwendeten Testsystemen der Anmelderin sind Flip-Flop Kippschaltungen mit Set(Setz)-, Reset(Rücksetz)- und Clock(Takt)-Eingängen sowie XOR-Schaltungen mit unterschiedlichen Signallaufzeiten vom Eingang zum Ausgang vorgesehen.)

Dieser Nachteil kann auch durch sogenanntes "Interleave"-zeitliches Verschachteln oder "Ordern" zweier oder mehrerer für sich gesehen "langsamer" Signalfolgen - nicht überwunden werden, da hierbei wiederum die zuvor erwähnten XOR-Schaltungen in Anwendung kommen.

Bekannte Interleave-Schaltungen haben es bisher schaltungsbedingt im Echtzeitbetrieb nur erlaubt, Signale gleichbleibender Polarität zu verknüpfen.

Dadurch sind funktionelle Einschränkungen im Interleave-Echtzeit-Testbetrieb bedingt.

Es ist deshalb Aufgabe der Erfindung, für die immer "schneller" werdenden auszutestenden Produkte, wie Speicher und Digitalschaltungen, Testsysteme vorzugeben, welche eine höhere zeitliche Genauigkeit aufweisen und für universell im Interleave-Echtzeitbetrieb selektierbare Prüfsignalformate geeignet sind. Ebenso ist es aus allgemeiner Sicht Aufgabe der Erfindung, digitale Steuersignale hoher zeitlicher Genauigkeit aus Daten- und Zeitgebersignalen insbesondere für Computersteuerungen zu erzeugen.

Diese Aufgabe der Erfindung wird durch die in den Hauptansprüchen angegebenen Maßnahmen gelöst. Weitere vorteilhafte Ausgestaltungen der Erfindung sind in den Unteransprüchen charakterisiert.

Ein Ausführungsbeispiel der Erfindung ist in den Zeichnungen dargestellt und wird im folgenden näher beschrieben. Es zeigen:
Fig. 1A ein schematisches vereinfachtes Blockschaltbild zur Erzeugung von Prüfsignalen nach dem Stand der Technik,
Fig. 1B ein schematisches Blockschaltbild eines Testsystemes nach dem Stand der Technik unter Berücksichtigung der Erzeugung der Daten- und Zeitgebersignale
Fig. 2 ein schematisches Blockschaltbild zur erfindungsgemäßen Erzeugung von Prüfsignalen.
Fig. 3 ein Zeitdiagramm für Prüf-, Zeitgeber- und Datensignale in zwei Impulsintervallen (Zyklen),
Fig. 4 eine Übersicht verschiedener Prüfsignalformate
Fig. 5 eine tabellarische Darstellung für Prüfsignale hinsichtlich der jedem Prüfsignal zugeordneten Formatierungs- und Zeitgeberschaltung, der Polarität und der logischen Bedeutung des Signalwertes und der Prüfsignalformate,
Fig. 6 ein Blockschaltbild zur Erzeugung der Prüfsignale aus Datensignalen und Zeitgebersignalen mittels einer Reihe von Formatierungsschaltungen und Zeitgeberschaltungen, welche jeweils einem Datensignal zugeordnet sind,
Fig. 7 ein Blockschaltbild einer Formatierungsschaltung,
Fig. 8 eine Funktionsübersicht eines Formatspeichers,
Fig. 9 ein Blockschaltbild eines Format-pre-Dekoders
Fig. 10 ein Blockschaltbild für eine Verknüpfungsschaltung (2-3 in Fig. 2 bzw. 7-2 in Fig. 7),
Fig. 11 ein Blockschaltbild zur Pulsformung der Prüfsignale mehrerer Kanäle,
Fig. 12 ein Blockschaltbild der Format-Pipeline-Schaltung (7-13 in Fig. 7)
Fig. 13 ein Blockschaltbild einer Verzögerungsschaltung für die Format-Pipeline-Schaltung
Fig. 14 ein Blockschaltbild zur Funktionsprüfung eines auszutestenden Produktes.

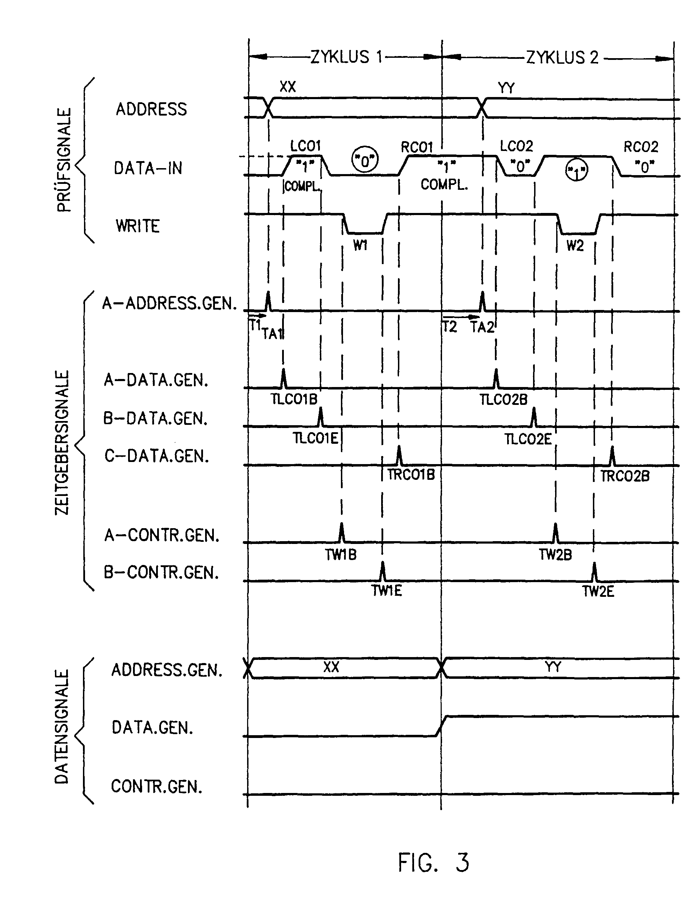

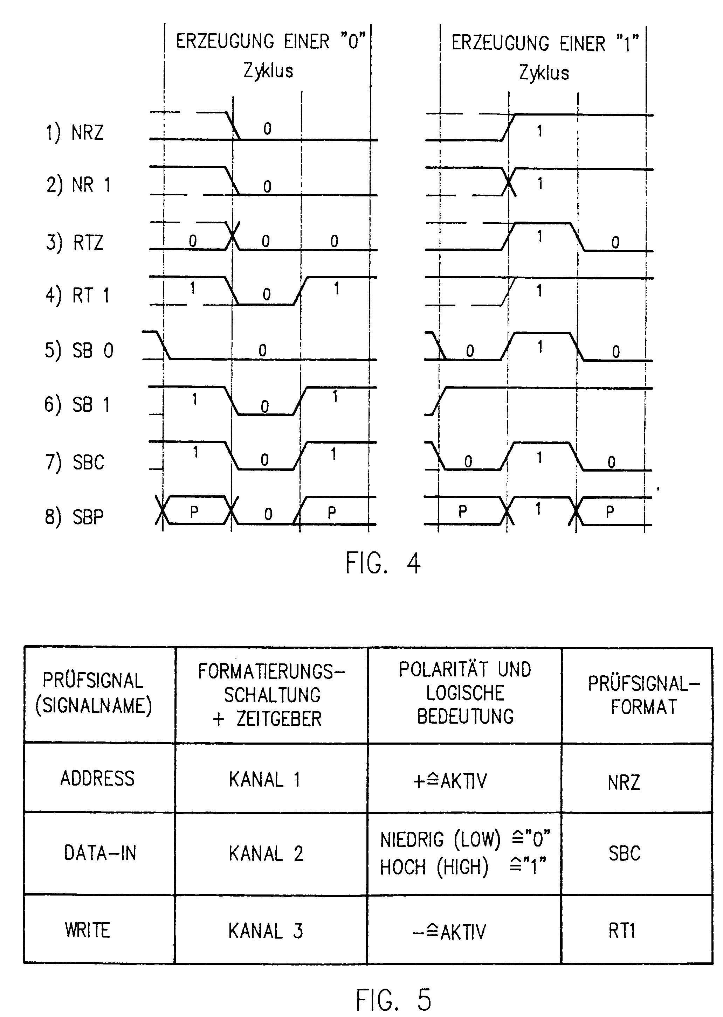

Für das Verständnis der Erfindung ist zunächst eine Kenntnis des Zusammenwirkens von Prüf-, Daten- und Zeitgebersignalen sowie eine Kenntnis von Prüfsignalformaten (Fig. 4) erforderlich. Ein Beispiel für Prüf-, Daten- und Zeitgebersignale ist in Zusammenhang mit Fig. 3 beschrieben.

Je nach den Anforderungen für den Test eines Produktes müssen die Prüfsignale bestimmte Formate aufweisen, welche den Signalverlauf innerhalb der einzelnen Impulsintervalle (im folgenden Zyklen genannt) kennzeichnen. Einzelheiten zu Prüfsignalformaten werden in der Beschreibung in Zusammenhang mit Fig. 4 beschrieben.

Nach dem Stand der Technik war es erforderlich, für jedes erforderliche Prüfsignalformat eine entsprechende Prüfsignal-format- spezifische Hardwareschaltung 1-1 (Fig. 1A) vorzugeben. Dieser Schaltung wurden als Eingangssignale die Datensignale und Zeitgebersignale zugeführt. Ein solches Datensignal kann z.B. eine Adreßinformation für einen Zyklus sein oder Angaben beinhalten, wonach in einem Zyklus das zu prüfende Produkt mit einer binären "0" bzw. einer binären "1" zu beaufschlagen ist. Die Datensignale können auch Steuerinformationen umfassen, z.B. ob Information in das zu prüfende Produkt einzuschreiben ist oder ob Information auszulesen ist. Auf die Beschreibung der Datensignale in Zusammenhang mit Fig. 3 wird verwiesen.

Die Zeitgebersignale (siehe auch Fig. 3) geben die Zeitpunkte innerhalb der Zyklen vor, zu denen entsprechende Daten bzw. zu denen entsprechende Steuerinformation zur Verfügung gestellt werden müssen. So wird beispielsweise der Zeitpunkt des Anfangs und des Endes einer Zeitspanne durch die Zeitgebersignale gekennzeichnet, während der das zu prüfende Produkt mit einer binären "0" zu beaufschlagen ist. Aus solchen Datensignalen und Zeitgebersignalen wird für ein bestimmtes Prüfsignalformat das Prüfsignal erzeugt. Für das z.B. in Fig. 3 für das Prüfsignal "DATA-IN" zugrundeliegende Format SBC (Surround by Complement) würde die für dieses SBC-Format spezifische Hardwareschaltung 1-1 aus dem entsprechenden Datensignal Data.GEN und den entsprechenden Zeitgebersignalen A-DATA.GEN., B-DATA.GEN., C-DATA.GEN. das Prüfsignal "DATA-IN" erzeugen. Für andere Prüfsignalformate hat die Hardwareschaltung 1-1 einen entsprechenden anderen Aufbau. Solche Prüfsignal-formatspezifischen Hardwareschaltungen nach dem Stand der Technik sind jedoch wie bereits erwähnt mit einer Reihe von Nachteilen behaftet, insbesondere mit einer für "schnelle" Tests nicht ausreichenden zeitlichen Genauigkeit.

In Fig. 2 ist ein schematisches Blockschaltbild zur erfindungsgemäßen Erzeugung von Prüfsignalen dargestellt. Die Prüfsignale werden aus Datensignalen und Zeitgebersignalen unter Angabe des erforderlichen Prüfsignalformates erzeugt. Der Erzeugung der Zeitgebersignale dient ein Zeitgeber 2-2, wie er z.B. nach dem Stand der Technik aus der Europäischen Patentschrift 0128228 bekannt ist. Ein solcher Zeitgeber ist für jeweils ein bestimmtes Datensignal erforderlich. Der Zeitgeber 2-2 erhält die Zeitwerte aus einem ihm vorgeschalteten Zeitgeber-Speicher 1-9. Die Erzeugung des Prüfsignales erfolgt in dem Block 2-0. Zum besseren Verständnis der Wirkungsweise der in Fig. 2 wiedergegebenen Schaltung sei zunächst auf Fig. 3 verwiesen. Dort ist ein Zeitdiagramm für ein Beispiel vorgegebener Prüf-, Zeitgeber- und Datensignale in zwei Zyklen gezeigt. Das Beispiel bezieht sich auf Spezifikationen zum Austesten eines Halbleiterspeichers:
Zyklus 1 5 nsec
Zyklus 2 6 nsec.

Für den auszutestenden Halbleiterspeicher gelten für die Prüfsignale "ADDRESS", "DATA-IN" und "WRITE" die angegebenen Werte. Für den Zyklus 1 wird die vorgegebene Adresse XX über Kanal 1 (siehe auch Fig. 5) adressiert, für den Zyklus 2 ist die Adresse YY vorgegeben. Die Adressierung erfolgt über entsprechende Adreßleitungen, welche durch zumeist binäre Signale aktiviert werden.

Sämtliche Prüfsignale haben einem vorgegebenen Format zu entsprechen. Einzelheiten zu den Prüfsignalformaten sind in Zusammenhang mit Fig. 4 beschrieben. Im Falle des Prüfsignales "ADDRESS" ist das Format NRZ (Non return to Zero = nicht auf Null zurückgehen) vorgesehen. Dem Prüfsignal "DATA-IN" (Fig. 3, Fig. 5) wird für einen niedrigen Spannungslevel (low) die Bedeutung einer logischen "0" und für einen hohen Spannungslevel die Bedeutung einer logischen "1" zugeordnet. Für das Prüfsignal "DATA-IN" ist das Format SBC vorgesehen (SBC = surrounded by complement = von Komplementwerten umgeben, d.h. eine logische "0" ist von logischen "1"en, eine logische "1" ist von logischen "0"en umgeben).

Das Prüfsignal "WRITE" (Fig. 3, Fig. 5) - während dieses Signales kann an die adressierte Stelle des Speichers die "DATA-IN"-Information geschrieben werden - ist für einen negativen Spannungslevel "-" aktiv. Dieses Prüfsignal "WRITE" erscheint im Format RT1 (return to 1 = kehre auf eine logische "1" zurück). Im Zyklus 1 ist eine logische "0" in die Adresse XX, im Zyklus 2 eine logische "1" in die Adresse YY zu schreiben. In Fig. 3 sind in zeitlich aufeinander ausgerichteter Form die in Zyklus 1 und Zyklus 2 auftretenden Spannungsverläufe und Impulse dargestellt: Im Zyklus 1 ist ab dem Zeitpunkt T1 (gerechnet ab Beginn des Zyklus 1) die Adresse XX aktiviert; im Zyklus 2 ist ab dem Zeitpunkt T2 (gerechnet ab Beginn des Zyklus 2) die Adresse YY aktiviert.

Während des Prüfsignales "WRITE" im Zyklus 1 und Zyklus 2 soll in die jeweils adressierte Stelle XX bzw. YY des Speichers Information, nämlich eine logische "0" im Zyklus 1 und eine logische "1" im Zyklus 2, geschrieben werden.

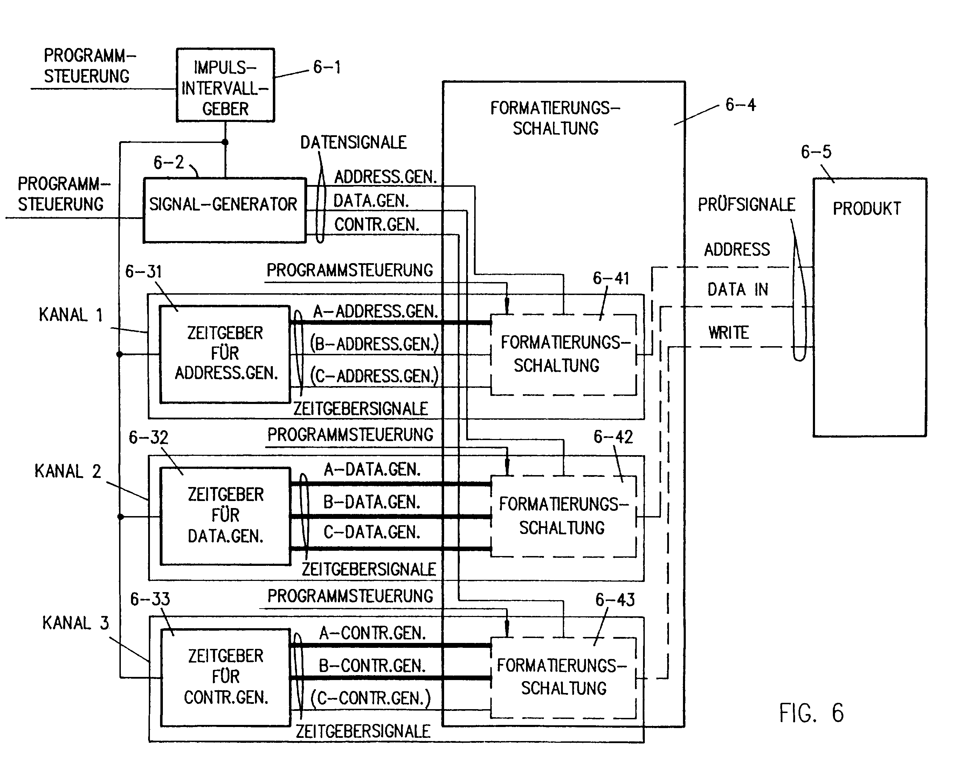

Da das Prüfsignal "DATA-IN" dem SBC Format genügen muß, weist dieses im Zyklus 1 beidseits der "0" das erforderliche "1" Komplement LCO1 und RCO1 und im Zyklus 2 beidseits der "1" das erforderliche "0" Komplement LCO2 und RCO2 auf. Das Prüfsignal "ADDRESS" (auf Kanal 1 in Fig. 5), das Prüfsignal "DATA-IN" (auf Kanal 2 in Fig. 5) und das Prüfsignal "WRITE" (auf Kanal 3 in Fig. 5) entsprechen gemäß Fig. 3 vorgegebenen Produktspezifikationen. An diesen Vorgaben haben sich die Zeitgeber 6-31, 6-32 und 6-33 zur Erzeugung von Zeitgebersignalen und ein Signalgenerator 6-2 zur Erzeugung von Datensignalen (Fig. 6) zu orientieren, um aus ursprünglich digital vorgegebenen Werten für die Prüfsignale Impulse und Spannungsverläufe zeitgenau zu erzeugen. Aus den Zeitgeber- und Datensignalen werden schaltungsgesteuert die Prüfsignale erzeugt. Der Zeitgeber 6-31 in Fig. 6 für das Datensignal "ADDRESS.GEN" (Fig. 6, Fig. 3) erzeugt in einer sogenannten "Zeitebene A", auf deren Bedeutung später detailiert eingegangen wird, die den Beginn des Zyklus 1 und Zyklus 2 kennzeichnenden Zeitpunkte und die die Startzeitpunkte für die Adressierung kennzeichnenden Pulse TA1 bzw. TA2 für die Zyklen 1 und 2. Der Begriff Zeitebene A deutet in diesem Zusammenhang auf eine von anderen Zeitebenen B und C getrennte Pulserzeugung hin. Die Ausgänge der verschiedenen Zeitebenen werden über entsprechende Formatierungsschaltungen (6-41, 6-42, 6-43) letztlich zur jeweiligen Generierung der Prüfsignale zusammengeführt.

Für das Datensignal "DATA.GEN." sind die Zeitgebersignale der Zeitebenen A, B und C mit "A-DATA.GEN.", "B-DATA.GEN." und "C-DATA.GEN." bezeichnet (Fig. 3, Fig. 6). In der Zeitebene A werden durch "A-DATA.GEN." in den Zyklen 1 bzw. 2 die Impulse TLCO1B und TLCO2B vorgegeben, welche den Beginn der linken Komplementpulse LCO1 bzw. LCO2 im Zyklus 1 und 2 kennzeichnen. In der Zeitebene B hingegen werden durch "B-DATA.GEN." die Pulse TLCO1E TLCO2E vorgegeben, welche das Ende von LCO1 bzw. LCO2 kennzeichnen.

In der Zeitebene C werden durch "C-DATA.GEN." die Pulse TRCO1B bzw. TRCO2B vorgegeben, welche den Beginn der rechten Komplementpulse RCO1 bzw. RCO2 im Zyklus 1 bzw. 2 für "DATA-IN" kennzeichnen.
Für das Datensignal "CONTR.GEN." werden durch "A-CONTR.GEN" die Pulse TW1B bzw. TW2B vorgegeben, welche den Beginn der WRITE-Pulse W1 bzw. W2 kennzeichnen; in der Zeitebene B werden durch "B-CONTR.GEN." die Pulse TW1E bzw. TW2E vorgegeben, welche das Ende der WRITE-Pulse W1 bzw. W2 markieren.

In Fig. 4 ist eine Übersicht für die für Testzwecke erforderlichen Prüfsignalformate wiedergegeben. Als Abzisse erscheint die Zeitachse; als Ordinate die Impulsamplitude. Die Darstellung erstreckt sich auf einen Zyklus, sowohl für die Erzeugung einer logischen "0" (linke Spalte) als auch einer logischen "1" (rechte Spalte). Den binären Spannungsniveaus der Impulse sind die Werte logisch Null "0" bzw. logisch Eins "1" zugeord- net. Der Zyklus ist in drei Abschnitte aufgeteilt. Jedem Abschnitt ist eine logische "0" oder "1" zugeordnet.

Die Formatebezeichnungen bedeuten:

| | | |
|---|---|---|
| NRZ | non return to zero ("0") | (nicht auf "0" zurückkehren) |
| NR'1' | non return to "1" | (nicht auf "1" zurückkehren) |
| RTZ | return to zero ("0") | (auf "0") zurückkehren) |
| RT'1' | return to "1" | (auf "1" zurückkehren ) |
| SB'0' | surrounded by "0" | (umgeben von "0") |
| SB'1' | surrounded by "1" | (umgeben von "1") |
| SBC | surrounded by complement | (vom Komplement umgeben) |
| SBP | surrounded by previous | (von dem Datenwert des vorausgehenden Zyklus umgeben) |

Für das Prüfsignalformat NRZ ist der Spannungsverlauf wie folgt zu verstehen:

Bei der Erzeugung einer "0" (linke Spalte) im mittleren Zeitabschnitt des Zyklus' können zwei Möglichkeiten auftreten, das Spannungsniveau im linken Zeitabschnitt liegt bei Null (stark ausgezogen) oder Eins (gestrichelt). Nach der Erzeugung der "0" im mittleren Zeitabschnitt verbleibt das Spannungsniveau im rechten Zeitabschnitt bei Null; ein auf Grund des Formates verbotenes Zurückkehren auf "Null" ist hierbei ohne Belang, da im mittleren Zeitabschnitt das Signalniveau bei Null und nicht bei Eins lag (im letzteren Fall dürfte das Signalniveau im rechten Zeitabschnitt nicht auf Null zurückgehen.

Bei der Erzeugung einer "1" (rechte Spalte) im mittleren Zeitabschnitt des Zyklus' können wiederum zwei Möglichkeiten auftreten: Das Spannungsniveau im linken Zeitabschnitt liegt bei Eins (gestrichelt) oder bei Null (ausgezogen). Nach der Erzeugung der logischen Eins im mittleren Zeitabschnitt darf auf Grund der Vorgabe des Prüfsignalformates (nicht auf Null zurückzukehren) das Spannungsniveau im rechten Zeitabschnitt nicht mehr auf Null absinken.

Analoge Erklärungen wie im vorhergehenden Beispiel gelten auch für die anderen Prüfsignalformate.

Die verschiedenen Formate sind dadurch gekennzeichnet, daß sich pro Zyklus entweder eine Zustandsänderung (z.B. bei NRZ), zwei Zustandsänderungen (z.B. bei RT1) oder drei Zustandsänderungen (z.B. bei SB0 oder SBC) ergeben. Im Format SBP (P abgeleitet von previous = vorausgehend) ist entsprechend die logische "1" im mittleren Abschnitt des Zyklus n+1 von den gleichen logischen Werten (in diesem Falle "1") umgeben wie die logische "0" im mittleren Abschnitt des Zyklus n.

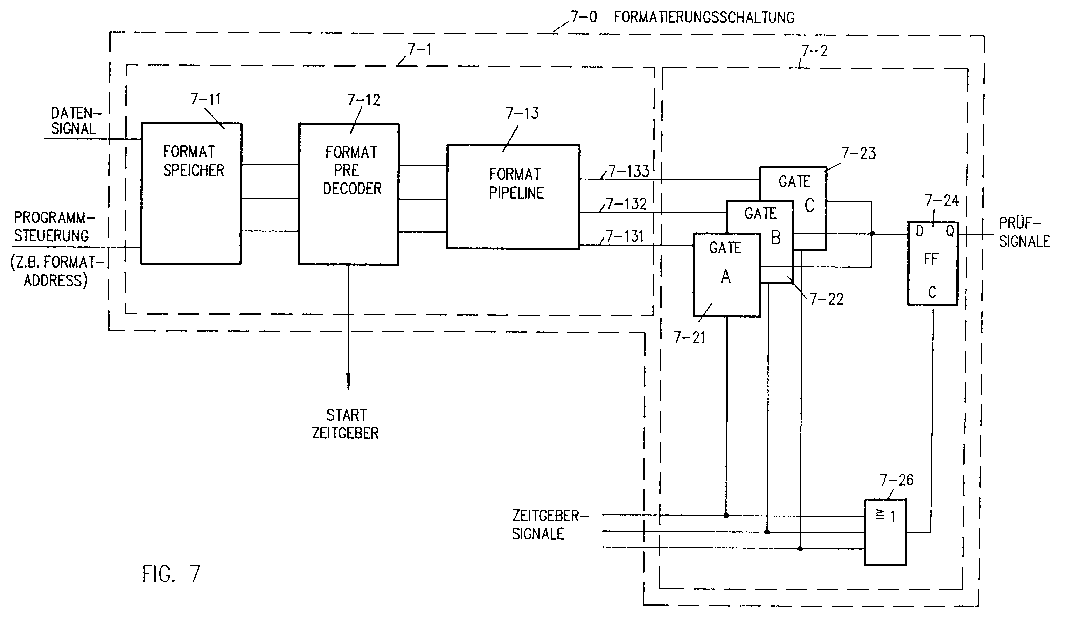

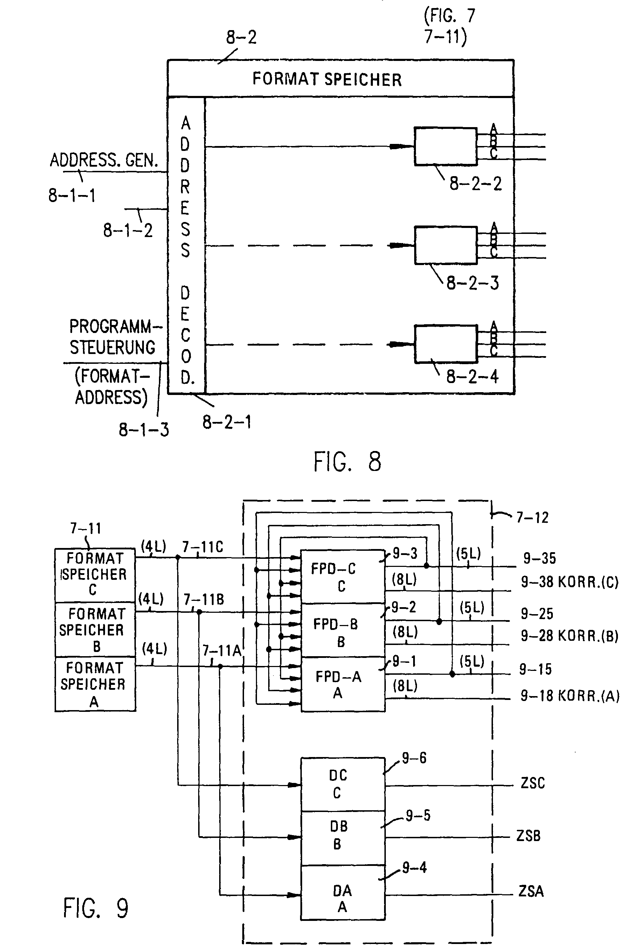

Nach Kenntnis der Prüf-, Zeitgeber- und Datensignale aus Fig. 3 ist es nunmehr leichter, die Wirkungsweise der in Fig. 2 gezeigten Schaltung zu verstehen. Wie bereits erwähnt, erfolgt die Erzeugung eines Prüfsignales in dem Block 2-0, Formatierungsschaltung genannt. Diese Formatierungsschaltung besteht aus zwei wesentlichen Teilen: Einer Schaltung zur Prüfsignal-Formaterzeugung ohne Zeitrelation 2-1 (Einzelheiten einer solchen Schaltung sind z.B. in Fig. 7 im Block 7-1 wiedergegeben) und einer Verknüpfungsschaltung 2-3 (von der weitere Einzelheiten in Fig. 7 im Block 7-2 wiedergegeben sind). Der Block 2-1 erzeugt aus dem Datensignal unter programmgesteuerter Angabe der Formatinformation zeitparallel pro Zyklus verfügbare Prüfsignal-Formatinformation ohne Zeitrelation und ein Startsignal für den Zeitgeber 2-2. Die Verknüpfungsschaltung 2-3 verknüpft die Prüfsignal-Formatinformation des Blocks 2-1 und die Zeitgebersignale des Zeitgebers 2-2 zu dem Prüfsignal. Die Besonderheit der Prüfsignal-Formatinformation ohne Zeitrelation am Ausgang des Blocks 2-1 liegt darin, daß hier die formatierten Datensignale pro Zyklus ohne Zeitbezug auf den Beginn des Zyklus erscheinen und zwar in zeitparallel verfügbarer Form. Mit anderen Worten: Für ein Prüfsignal, z.B. "DATA-IN" im Zyklus 1 in Fig. 3 würde auf drei Parallelausgängen 2-11, 2-12, 2-13 des Blocks 2-1 folgende Information in binär verschlüsselter Form auftreten:
Oberste Leitung 2-11: Gehe auf "1";
Mittlere Leitung 2-12: Gehe auf "0";
Unterste Leitung 2-13: Gehe auf "1".

Dies bedeutet, daß ohne Festlegung der Zeitpunkte innerhalb des Zyklus 1 der serielle Verlauf des "DATA-IN"-Signales mit zunehmender Zeit ("1"-Komplement LCO1 gefolgt von einer logischen "0", wiederum gefolgt von einem "1"-Komplement RCO1) durch die Angaben
Gehe auf "1"-
Gehe auf "0"-
Gehe auf "1"
gekennzeichnet ist. Diese den zeitseriellen Verlauf des "DATA-IN"-Signales kennzeichnenden Werte stehen an den entsprechenden Ausgängen des Blocks 2'1 zeitparallel, d.h. zur gleichen Zeit, zur Verfügung. Dadurch ist es möglich, bereits zu einem beliebigen Zeitpunkt in einem Zyklus über eine Aussage zu dem seriellen Signalverlauf (ohne Zeitrelation) innerhalb des gesamten Zyklus zu verfügen. Diese Prüfsignal-Formatinformation wird nun mit den Zeitgebersignalen in der Verknüpfungsschaltung 2-3 dahingehend verknüpft, daß letztgenannte Schaltung den seriellen Verlauf der Prüfsignale innerhalb eines Zyklus auf die durch die Zeitgebersignale festgelegten Zeitpunkte bezieht und somit das Prüfsignal in seinem zeitgetreuen seriellen Verlauf z.B. "DATA-IN" in Fig. 3, erzeugt.

Am Beispiel des Prüfsignales "DATA-IN" in Fig. 3 und 6 sei im Zusammenhang mit der in Fig. 7 gezeigten Schaltung auch der Begriff verschiedener Zeitebenen A, B, C erläutert. Das dem Prüfsignal "DATA-IN" zugrundeliegende Format SBC (surround by complement) beinhaltet pro Zyklus drei Zustandsänderungen, nämlich den Übergang vom "1"-Komplement LCO1 auf logisch "0" und ein nachfolgenden Übergang wieder auf ein "1"-Komplement RCO1 im Zyklus 1 oder im Zyklus 2 den Übergang vom "0"-Komplements LCO2 auf logisch "1" und den nachfolgenden Übergang auf das "0"-Komplement RCO2. Für die Angaben im Zyklus 1: "1"-"0"-"1" wird in einer ersten Zeitebene, der sogenannten A-Zeitebene, der Beginn des "1"-Komplements LCO1 durch einen Puls TLCO1B (Zeitgebersignal "A-DATA.GEN.", Fig. 3) gekennzeichnet. Das Ende des "1"-Komplements LCO1 wird durch den Puls TLCO1E in einer zweiten, der sogenannten B-Zeitebene, gekennzeichnet. Das diesbezügliche Zeitgebersignal ist in Fig. 3 mit "B-DATA.GEN." gekennzeichnet. Der Impuls TLCO1E leitet zugleich den Beginn der logischen "0" in "DATA-IN" ein, dessen Ende mit dem Beginn des nachfolgenden "1"-Komplements RCO1 zusammenfällt. Dieser Zeitpunkt wird durch einen Puls TRCO1B in einer sogenannten dritten Zeitebene C gekennzeichnet. Das betreffende Zeitgebersignal ist mit "C-DATA.GEN." bezeichnet. Somit gibt es für das Prüfsignal "DATA-IN" drei Zeitebenen für die Zeitgebersignale. Am Ausgang der Schaltung 2-1 in Fig. 2 sind deshalb drei diesen Zeitebenen entsprechende Leitungen 2-11, 2-12, 2-13 vorgesehen.

Die Leitung 2-11 beinhaltet die Information
gehe auf "1";
die Leitung 2-12 die Information: gehe auf "0" und die Leitung 2-13 gehe auf "1". In der Verknüpfungsschaltung 2-3 der Fig. 2 werden wie im Zusammenhang mit Fig. 7 noch ausführlicher beschrieben, die Informationen der Leitungen 2-11, 2-12 und 2-13 mit den entsprechenden Zeitgebersignalen für die Zeitebenen A, B, C zu dem Prüfsignal, in diesem Fall zu "DATA-IN", verknüpft. Es sei in diesem Zusammenhang bemerkt, daß je nach der Anzahl von Zustandsänderungen in einem Prüfsignalformat pro Zyklus eine unterschiedliche Anzahl von Zeitebenen zu berück- sichtigen ist. Im vorliegenden Beispiel des Prüfsignales "DATA-IN" mit dem Format SBC sind drei Zeitebenen vorgesehen, jedoch ist für andere Format mit einer kleineren oder höheren Zahl von Zustandsänderungen eine entsprechend kleinere oder höhere Zahl von Zeitebenen erforderlich. Praktisch ist jede Schaltung 2-1 zur Prüfsignal-Formaterzeugung ohne Zeitrelation und jede Zeitgeberschaltung 2-2 mit einer maximalen Anzahl von Zeitebenenversehen, die der maximal möglichen Zahl von Zustandsänderungen in einem der vorkommenden Prüfsignale entspricht. Die in Fig. 3 wiedergegebenen Prüfsignale "ADDRESS", "DATA-IN" und "WRITE" haben die Formate NRZ, SBC und RT1 (Fig. 5 und 4). Für das Format SBC oder RT1 ergeben sich drei Zustandsänderungen. Für Prüfsignale mit einer geringeren Zahl von Zustandsänderungen werden von den für sie vorgesehenen Schaltungen, z.B. Zeitgeber für "ADDRESS.GEN." in Fig. 6 oder die Ausgänge des entsprechenden Schaltungsblocks 7-1 in Fig. 7, nur diejenigen Zeitebenen aktiviert, welche entsprechend der Anzahl der Zustandsänderungen im Prüfsignalformat erforderlich sind. Die verbleibenden Ausgänge bleiben unberücksichtigt. Im Falle des Zeitgebers 6-31 in Fig.6 bleiben die Ausgänge für "B-ADDRESS.GEN." und "C-ADDRESS.GEN." für das Datensignal "ADDRESS.GEN." unberücksichtigt. In der entsprechenden Schaltung zur Prüfsignal-Formaterzeugung ohne Zeitrelation 7-1 für dieses Prüfsignal blieben die Ausgänge 7-132 und 7-133 unberücksichtigt, ausgenommen der der A-Zeitebene entsprechende Ausgang 7-131.

Einzelheiten des Schaltungsblockes 2-0 in Fig. 2 sind in Fig. 7 wiedergegeben. Fig. 6 zeigt ein Blockschaltbild zur Erzeugung der Prüfsignale aus den Datensignalen und Zeitgebersignalen mittels einer Reihe von Formatierungs- und Zeitgeberschaltungen, die jeweils einem Datensignal zugeordnet sind. Dieses Blockschaltbild bezieht sich auf die in Fig. 3 wiedergegebenen Prüfsignale "ADDRESS", "DATA-IN" und "WRITE". Der Impulsintervallgeber 6-1 erzeugt programmgesteuert gemäß DE-A-28 297 09 Impulsintervalle (Zyklen). Die Zeitdauer jedes Zyklus ist als digitaler Wert per Programm vorgegeben.

Der Impulsintervallgeber 6-1 ist mit einem Signalgenerator 6-2 zur Erzeugung der Datensignale "ADDRESS.GEN.", "DATA.GEN." und "CONTR.GEN." und mit den Zeitgeberschaltungen zur "zeitlichen Synchronisation" verbunden. Die Erzeugung dieser Signale erfolgt ebenfalls programmgesteuert unter Vorgabe der den Verlauf dieser Signale kennzeichnenden digitalen Werte. Für jedes dieser Datensignale ist jeweils ein Zeitgeber erforderlich:
Für das "ADDRESS.GEN."-Signal der Zeitgeber 6-31,
für das "DATA.GEN."-Signal der Zeitgeber 6-32 und
für das "CONTR.GEN."-Signal der Zeitgeber 6-32.

Jeder der Zeitgeber hat eine der Anzahl der Zeitebenen (im vorgegebenen Beispiel sind es drei Zeitebenen A, B und C) entsprechende Zahl von Ausgängen, die im Falle 6-31 für die Zeitgebersignale mit "A-ADDRESS.GEN.", "B-ADDRESS.GEN." und "C-ADDRESS.GEN."; im Falle 6-32 für die Zeitgebersignale mit "A-DATA.GEN.", "B-DATA.GEN." und "C-DATA.GEN." und im Falle 6-33 für die Zeitgebersignale mit "A-CONTR.GEN.", "B-CONTR.GEN." und "C-CONTR.GEN." bezeichnet sind. Von diesen Ausgängen werden nur diejenigen für die Erzeugung der Prüfsignale "ADDRESS", "DATA.IN" und "WRITE" wirksam, welche den jeweils erforderlichen Zeitebenen entsprechen. Für "ADDRESS" (Fig. 3) ist nur die Zeitebene A erforderlich - zur Verdeutlichung ist deshalb "A-ADDRESS.GEN." in Fig. 6 stark ausgezogen. Wegen der nicht erforderlichen Zeitebenen B und C bleiben die Ausgänge für "B-ADDRESS.GEN." und "C-ADDRESS.GEN." unberücksichtigt (sie sind deshalb nur schwach ausgezogen). Für "DATA-IN" sind die Zeitebenen A, B, C erforderlich - zur Verdeutlichung sind die Ausgänge von 6-32 für "A-DATA.GEN.", "B-DATA.GEN." und "C-DATA.GEN." stark ausgezogen. Für "WRITE" sind nur die Zeitebenen A und B erforderlich - zur Verdeutlichung sind die Ausgänge von 6-33 für "A-CONTR.GEN." und "B-CONTR.GEN." stark ausgezogen.

Die Formatierungsschaltung 6-4 besteht aus einer der Anzahl der Datensignale (im vorliegenden Beispiel sind es 3) des Signalgenerators 6-2 entsprechenden Anzahl von (drei) Formatierungsschaltungen:

Formatierungsschaltung 6-41, 6-42 und 6-43. Die Formatierungsschaltung 6-41 ist mit dem Ausgang "ADDRESS.GEN." des Signalgenerators 6-2 und der Zeitgeberschaltung 6-31 verbunden. Der Zeitgeber 6-31 und die Formatierungsschaltung 6-41 bilden den Kanal 1 zur Erzeugung des Prüfsignals "ADDRESS".

Die Formatierungsschaltung 6-42 ist mit dem Ausgang "DATA.GEN." des Signalgenerators 6-2 und der Zeitgeberschaltung 6-32 zur Erzeugung des Prüfsignales "DATA-IN" verbunden. Die Formatierungsschaltung 6-42 und der Zeitgeber 6-32 bilden den Kanal 2.

Die Formatierungsschaltung 6-43 ist mit dem Ausgang "CONTR.GEN." des Signalgenerators 6-2 und der Zeitgeberschaltung 6-33 zur Erzeugung des Prüfsignales "WRITE" verbunden.
Die Formatierungsschaltung 6-43 und die Zeitgeberschaltung 6-33 bilden den Kanal 3.

Jede Formatierungsschaltung hat einen einheitlichen Aufbau, welcher in Fig. 7 in einem Blockschaltbild näher beschrieben ist.

Die Eingänge des Formatspeichers 7-11 beziehen sich auf das entsprechende Datensignal und auf eine per Programmsteuerung vorzugebende Information zur Kennzeichnung des Prüfsignalformates. Aus diesen Angaben werden am Ausgang des Formatspeichers die für die maximal mögliche Anzahl von Zeitebenen erforderlichen Prüfsignalformatangaben zur Verfügung gestellt. Zur Verdeutlichung dieses Hinweises wird in Fig. 8 aufgrund detaillierterer Angaben zum Formatspeicher 8-2 für das Beispiel des Datensignales "ADDRESS.GEN." die Funktion dieses Formatspeichers beschrieben. Die "ADDRESS.GEN."-Information auf der Eingangsleitung 8-1-1 und eine auf der Eingangsleitung 8-1-3 von der Programmsteuerung stammende Adresse (diese Adresse bezeichnet eine fiktive Stelle des Formatspeichers, an der Angaben zum Prüfsignalformat gespeichert sind) werden von einem Adreß-Decoder 8-2-1 ADDRESS DECODE. zu einer aktuellen Adresse 8-2-2 kombiniert, unter der im Formatspeicher 8-2 die Angaben für das Prüfsignalformat - hier NRZ - für die erforderlichen Zeitebenen A, B und C gespeichert sind. Für ein anderes Datensignal und/oder eine andere fiktive Formatadresse ergeben sich andere Speicherstellen (z.B. 8-2-3, 8-2-4) im Formatspeicher, an denen die entsprechenden Prüfsignalinformationen auszulesen sind.

Es sei bemerkt, daß eine zweite Eingangsleitung 8-1-2 vorgesehen werden kann für eine binäre Steuerinformation mit der Aussage darüber, ob das Prüfsignal hochohmig oder niederohmig geschaltet werden soll. Diese zusätzliche Information wird durch den Adreß-Decoder 8-2-1 entsprechend berücksichtigt.

Die Eingabeinformationen auf den Leitungen 8-1-1, 8-1-2 und 8-1-3 bestimmen also in ihrer Kombination eine bestimmte Adresse im Formatspeicher 8-2, unter der die Angabe gespeichert ist, welche Zeitebene (Zeitebenen) für die Erzeugung des in Frage stehenden Prüfsignalformates heranzuziehen ist (sind) und welche Binärinformation den seriellen Prüfsignalverlauf (ohne Zeitrelation) kennzeichnen. Aus dem Vorstehenden ergibt sich, daß der Formatspeicher 8-2 vorprogrammiert sein muß, um für alle möglichen Kombinationen der Signale und Formate eine eindeutige Zuordnung für die Zeitebenen der Prüfsignalformate zu enthalten.

Einzelheiten des Format-Predecoders 7-12 (Fig. 7) sind in Fig. 9 wiedergegeben. Der Format-Predecoder hat die Aufgabe, die vom Format-Memory 7-11 (Fig. 7) für jede Zeitebene (A,B,C) gelieferten codierten Signale (wie nachfolgend näher erläutert) in Signale auf bestimmten Leitungen (z.B. 9-15) umzusetzen, Daten-Signale aus vorausgehenden Zyklen zur Verfügung zu stellen und die START Signale für den Zeitgeber zu erzeugen, sowie mit bestimmten Leitungen (z.B. 9-18) einen Korrekturspeicher zu adressieren für die Aufnahme von Korrekturwerten KORR.(A),-(B),-(C) zum Ausgleich von Signal-Laufzeitunterschieden. Pro Zeitebene (A,B,C) werden vom Format-Memory 7-11 auf 4 Leitungen (4L) binär codierte Signale mit folgenden Aussagen geliefert:
- 0000: Daten = "0"
- 0001: Daten = "1"
- 0010: Daten aus vorausgehendem Zyklus der Zeitebene A
- 0011: Invertierte Daten aus vorausgehendem Zyklus der Zeitebene A
- 0100: Daten aus vorausgehendem Zyklus der Zeitebene B
- 0101: Invertierte Daten aus vorausgehendem Zyklus der Zeitebene B
- 0110: Daten aus vorausgehendem Zyklus der Zeitebene C
- 0111: Invertierte Daten aus vorausgehendem Zyklus der Zeitebene C
- 1000: Erzeugung eines Leseverstärkersignales (STROBE "0") zur Feststellung, ob eine binäre "0" als Daten in eine dafür vorgesehene Stelle des zu testenden Speicherproduktes geschrieben wurde (siehe auch Fig. 14)
- 1001: Erzeugung eines Leseverstärkersignales (STROBE "1") zur Feststellung, ob eine binäre "1" als Daten in eine dafür vorgesehene Stelle des zu testenden Speicherproduktes geschrieben wurde (siehe auch Fig. 14)
- 1010: Erzeugung von Leseverstärkesignalen (STROBE "0" & "1") zur Feststellung, ob eine binäre "0" oder/und "1" als Daten in eine dafür vorgesehene Stelle des zu testenden Speicherproduktes geschrieben wurde (siehe auch Fig. 14)
- 1011: Treiber hochohmig schalten (s. auch Fig. 14)
- 1100: Treiber niederohmig schalten (s. auch Fig. 14)
- 1101: Dynamische Last abschalten (s. auch Fig. 14)
- 1110: Dynamische Last zuschalten (s. auch Fig. 14)
- 1111: Keine Operation (NOOP)

Jede der Ausgangsleitungen (7-11A, 7-11B, 7-11C) des Formatspeichers 7-11 stellt in praxi mehrere Bit-Leitungen zur Parallel-Darstellung bestimmter Bit-Kombinationen dar.

Die Bit-Leitungen einer Ausgangsleitung, die jeweils einer Zeitebene zugeordnet ist, enthalten in codierter Form Angaben zur Zeitsteuerung (ob und wann Zeitgebersignale zu generieren sind) und die eigentlichen Daten (z.B. "gehe auch 0" oder "gehe auf eins"). Eine bestimmte Bit-Kombination ist für die Aussage vorgesehen, daß eine oder mehrere Zeitebenen für die Erzeugung eines bestimmten Prüfsignales nicht erforderlich sind (z.B. für A-ADDRESS. GEN in Fig. 6 ist nur die Zeitebene A, nicht aber die Zeitebene B und C erforderlich).

Die Ausgangsleitungen des Formatspeichers 7-11 für jede Zeitebene A, B, C sind in Fig. 7 und Fig. 9 mit 7-11A, 7-11B, 7-11C gekennzeichnet. Sie führen wie aus Fig. 9 ersichtlich zu Format-Pre-Decoder Schaltungen 9-1 FPD-A für die Zeitebene A, 9-2 FPD-B für die Zeitebene B und 9-3 FPD-C für die Zeitebene C.

Jede der Schaltungen 9-1, 9-2 und 9-3 haben jeweils ein 5 Leitungen (5L) umfassendes Ausgangsleitungsbündel 9-15, 9-25 bzw. 9-35 und jeweils ein 8 Leitungen (8L) umfassendes Ausgangsleitungsbündel 9-18, 9-28 bzw. 9-38.

Die jeweils 5 Leitungen umfassenden Ausgangsleitungsbündel führen folgende Information:
- Data: Diese Leitung führt die Dateninformation "0" oder "1"
- STROBE "0": Ein Signal auf dieser Leitung bedeutet, daß ein Leseverstärkersignal zur Feststellung einer "0" zu erzeugen ist.
- STROBE "1": Ein Signal auf dieser Leitung bedeutet, daß ein Leseverstärkersignal zur Feststellung einer "1" zu erzeugen ist.
- 3-STATE: Ein Signal auf dieser Leitung bedeutet, daß der Treiber hochohmig zu schalten ist.
- LOAD: Ein Signal auf dieser Leitung bedeutet, daß eine dynamische Last hinzuzuschalten ist.

Von diesen Ausgangsleitungen wird nur die Data-Leitung auf die Eingänge der Format-Pre-Decoder-Schaltungen 9-1, 9-2 und 9-3 zurückgeführt, damit für jede Zeitebene eine Aussage über vorangegangene Zeitebenen gemacht werden kann. Eine Format-Pre-Dekoder Schaltung hat die Aufgabe zu bestimmen, ob in einer Zeitebene eine Veränderung des Datensignales stattfinden soll. Wäre z.B. für das aktuelle Impulsintervall in der Zeitebene A für den ersten Pegelwechsel der Befehl "gehe auf 1" auszuführen, so braucht dieser Befehl nur ausgeführt zu werden, wenn der Pegel nach dem allerletzten Pegelwechsel des vorausgehenden Impulsintervalles noch nicht auf "1" steht. Nur für diesen Fall ist die Erzeugung eines Zeitgebersignals zu starten. Die Angaben, zu welchem Zeitpunkt (bezogen auf den Impulsintervallbeginn) das Zeitgebersignal vorzusehen ist, sind in codierter Form im Zeitgeber enthalten.

Die Rückbeziehung auf das Pegelniveau des vorausgehenden Impulsintervalles erfordert den durch 9-1, 9-2, 9-3 vorgegebenen Speicher. Sofern für eine Zeitebene des aktuellen Impulsintervalles ein Pegelwechsel bezogen auf das vorangehende Impulsintervall erforderlich ist (z.B. durch den Befehl "gehe auf 1") wird zu dem vorgesehenen Zeitpunkt die Erzeugung eines Zeitgebersignales bewirkt.

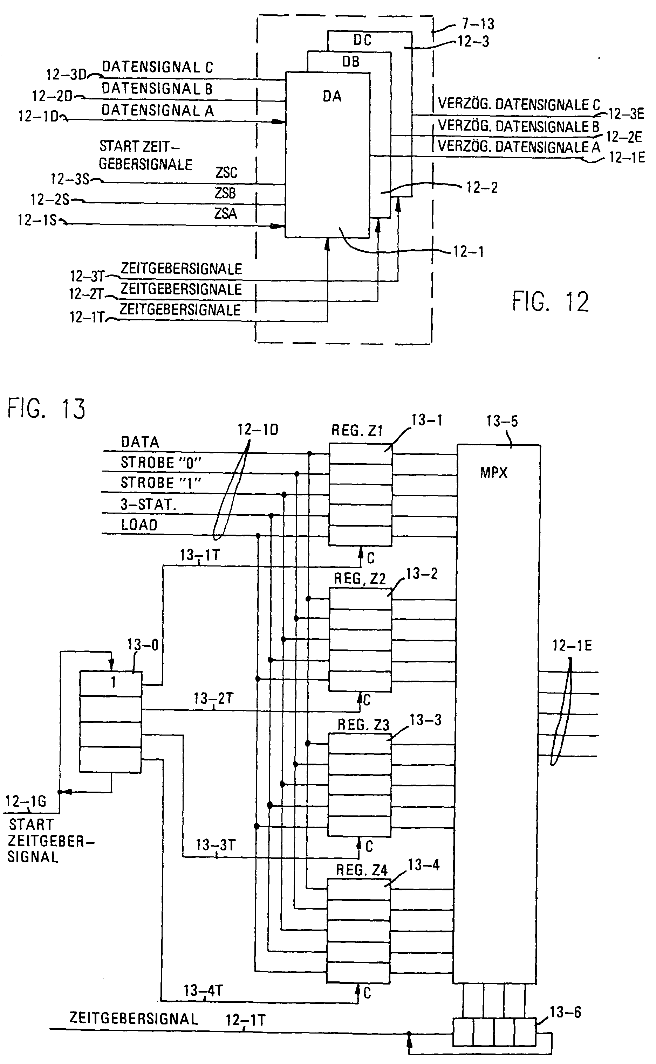

Die jeweils 8 Leitungen umfassenden Ausgangsleitungsbündel 9-18, 9-28, 9-38 dienen der Adressierung eines Korrekturspeichers. Dieser Speicher nimmt ermittelte Korrekturwerte auf, um Laufzeitunterschiede von Prüfsignalen auf verschiedenen Pfaden zum auszutestenden Produkt auszugleichen (wenn z.B. das Produkt mit einer Vielzahl von Daten auf verschiedenen Pfaden gleichzeitig beaufschlagt werden soll). Diese Unterschiede ergeben sich durch Leitungs- und Bauelement-Toleranzen und durch unterschiedliche Signalverzögerungen in den Pulsformer- oder Treiber-Schaltungen (Fig. 11, Fig. 14) in Abhängigkeit von Statuswechsel (von binär "0" auf "1" oder von binär "1" auf "0").

Derartige Signalverzögerungen können nach herkömmlichen Methoden (z.B. zählergesteuerte Zeitmessung) gemessen und erfaßt werden. Zur Kompensation der Verzögerungen wird die Schaltung zur Erzeugung der Zeitgebersignale mit entsprechenden Korrekturwerten beaufschlagt (wie in GE 983 012 im Zusammenhang mit Fig. 4, Addierer 508 beschrieben).

Im vorliegenden Fall müßte dieser Addierer mit einem zusätzlichen Addiereingang für den zuvor erwähnten Korrekturwert versehen werden.

Zur Erzeugung der Zeitgebersignale werden die Leitungen 7-11A, 7-11B und 7-11C auf die Detektorschaltungen (DA, DB, DC) 9-4, 9-5 und 9-6 für die Zeitebenen A, B und C geführt. Diese erzeugen ein Zeitgeberstartsignal (ZSA, ZSB, ZSC), wenn die (4) Eingangsleitungen von 9-4, 9-5 bzw. 9-6 eine von der Binärkombination 1111 (NOP) abweichende Information führen. Für 1111 ist die Erzeugung eines Startsignales nicht erforderlich. Die Implementierung einer solchen Detektorschaltung erfolgt üblicherweise als NAND-Schaltung (Nicht-Und-Schaltung bei positiver Logikdefinition).

Die in Fig. 7 mit 7-13 gekennzeichnete Format-Pipeline hat folgende Aufgabe: Variable Zeitverzögerung der Daten-Signale in Anpassung an die Zeitgebersignale. Das Erfordernis einer solchen variablen Zeitverzögerung ist wie folgt begründet: Sofern ein Zeitgebersignal erst am Ende eines Zyklus 1 oder gar erst im Zyklus 2 auftritt, wird die Einstellzeit des FlipFlops 7-24 (Fig. 7) gefährdet, da unter Umständen zu diesem Zeitpunkt die an seinem D-Eingang anliegende Dateninformation nicht mehr verfügbar ist. Aus diesem Grunde muß für spät im Zyklus oder im Folgezyklus auftretende Zeitgebersignale die Dateninformation verzögert werden.

Eine detaillierte Darstellung der Format-Pipeline 7-13 (Fig. 7) ist in Fig. 12 wiedergegeben. Für jede Zeitebene A, B, C ist eine Verzögerungsschaltung DA, DB, DC gekennzeichnet mit 12-1, 12-2, 12-3 vorgesehen. Jede dieser Schaltungen hat einen Dateneingang 12-1D (12-2D, 12-3D), einen Eingang 12-1S (12-2S, 12-3S) für das START-Zeitgeber-Signal, einen Eingang 12-1T (12-2T bzw. 12-3T für die Zeitgebersignale für die einzelnen Zeitebenen.

Jede Verzögerungsschaltung hat einen Ausgang 12-1E, 12-2E oder 12-3E für das verzögerte Datensignal.

Weitere Einzelheiten einer solchen Verzögerungsschaltung sind in Fig. 13 wiedergegeben. Die Ein- und Ausgangsleitungen tragen die gleiche Bezeichnung wie in Fig. 12. (Eine solche Verzögerungsschaltung ist auch im IBM Technical Disclosure Bulletin Vol. 24, No. 12, May 1982, S 6488, 6489 beschrieben. )

Die in Fig. 13 gezeigte Verzögerungsschaltung bezieht sich auf die Zeitebene A; für die anderen Zeitebenen sind jeweils weitere entsprechende Schaltungen erforderlich. Diese Schaltung ist auf das Abspeichern der Werte für 4 aufeinanderfolgende Zyklen Z1, Z2, Z3 und Z4 ausgelegt; mit anderen Worten, während des vierten Zyklus Z4 kann noch auf die Werte des ersten Zyklus zurückgegriffen werden.

Für die Speicherung dieser Werte (DATA, STROBE"0", STROBE "1", 3-STATE und LOAD) für die vier Zyklen sind die 5 Bit-Register
REG. Z1 (13-1) für den ersten Zyklus
REG. Z2 (13-2) für den zweiten Zyklus
REG. Z3 (13-3) für den dritten Zyklus
REG. Z4 (13-4) für den vierten Zyklus
vorgesehen.

Diese Register sind mit den Leitungen 12-1D (= 9-15 in Fig. 9) verbunden, jedes Register wird über eine Taktleitung 13-1T, 13-2T, 13-3T, 13-4T und 13-5T zur Aufnahme der Information der Leitungen 12-1D veranlaßt; die Taktleitung 13-1T ist während des Zyklus 1 aktiviert, die Taktleitung 13-2T ist während des Zyklus 2 aktiviert usw.

Jede Taktleitung ist mit einer Stufe eines umlaufenen 4 Bit umfassenden Schieberegisters 13-0 verbunden.

In diesem Schieberegister läuft von Stufe zu Stufe eine 1 im Takte der auf Leitung 12-1S auftretenden START-Zeitgebersignale um: Für den ersten Zyklus wird die oberste Stufe des Registers 13-0 und damit die Leitung 13-1T aktiviert; für den zweiten Zyklus die Leitung 13-2T etc.

Nach Ablauf des vierten Zyklus wird die für den fünften Zyklus auf den Leitungen 12-1D anstehende Information in das REG.Z1 13-1 geschrieben (in welchem bis dahin die Information für den ersten Zyklus stand). In den Registern 13-1 bis 13-4 werden somit die Informationen für vier aufeinanderfolgende Zyklen gespeichert. Diese Informationen werden über eine Multiplex-Schaltung 13-5 "selektiv" auf den Ausgangsleitungen 12-1E zur Verfügung gestellt. Die Multiplex-Schaltung MPX 13-5 wird in der Folge vier aufeinanderfolgender Zyklen aktiviert über die Ausgänge eines umlaufenden vierstufigen Schieberegisters 13-6, welches von den Zeitgebersignalen auf Leitung 12-1T fortgeschaltet wird.

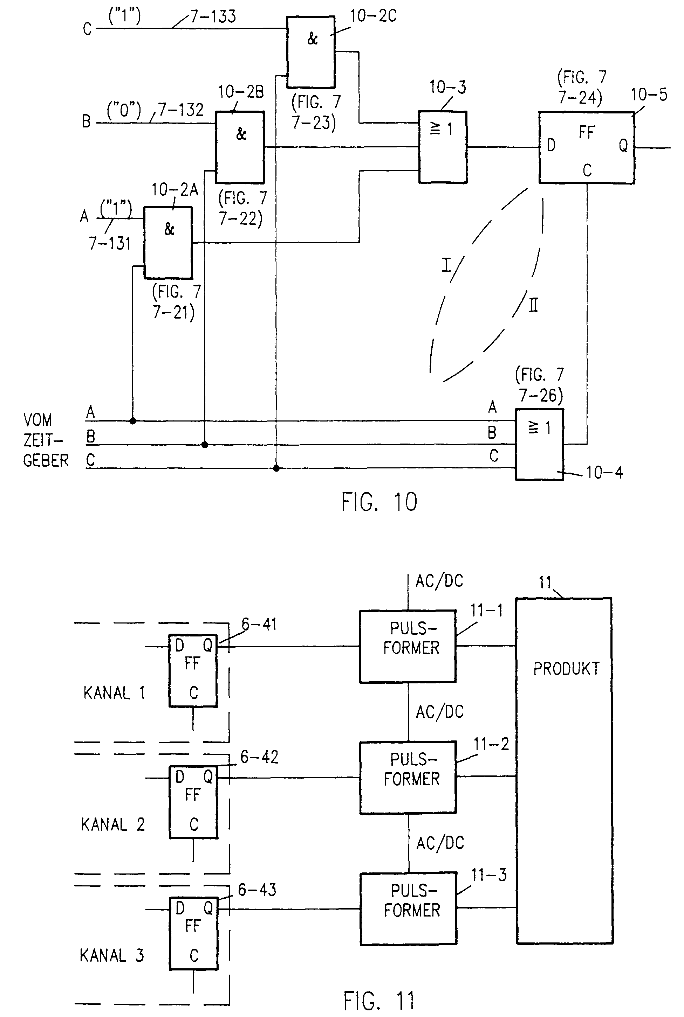

Fig. 10 zeigt ein Blockschaltbild für eine Verknüpfungsschaltung (2-3 in Fig. 2, 7-2 in Fig. 7).

Diese Verknüpfungsschaltung hat die Aufgabe, aus der zeitparallel pro Zyklus verfügbaren Prüfsignal-Formatinformation auf den Leitungen (2-11, 2-12, 2-13 in Fig. 2; 7-131, 7-132, 7-133 in Fig. 7) und den Zeitgebersignalen das Prüfsignal zu erzeugen (bzw. die Prüfsignal-Formatinformation mit den Zeitgebersignalen zum Prüfsignal zu verknüpfen). Dies bedeutet ein Umsetzen der zeitparallel verfügbaren Prüfsignal-Format-Information der Zeitebenen A,B,C in den gewünschten reellen zeitlichen Folgeablauf der Information.

Jede der Leitung 7-131, 7-132, 7-133 ist mit einer Und-Schaltung (GATE) A 7-21, B 7-22 und C 7-23 verbunden. Jede Zeitebene A, B, C erfordert eine solche Torschaltung.

Der zweite Eingang jeder Torschaltung wird direkt mit dem jeweiligen Zeitgebersignal der einzelnen Zeitebenen A, B, C beaufschlagt. Die Ausgänge aller Torschaltungen werden über ein Oder-Glied 10-3 zusammengeführt und dem D-Eingang einer Kippschaltung FF 7-24 zur Erzeugung des Prüfsignales zugeführt. Diese Kippschaltung wird über ihren Takteingang C durch die (über ein Oder-Glied 7-26) zusammengeführten Zeitgebersignale getaktet.

Das Prüfsignal steht am Ausgang Q des FF 10-5 auf der Leitung 10-6 zur Verfügung.

Die in Fig. 10 dargestellten Schaltungsteile sind zusätzlich mit Referenzhinweisen für Fig. 7 versehen, die darauf hinweisen, welchen Teilen in Fig. 7 sie entsprechen.

Die Zeitgebersignale der Zeitebenen A, B und C werden einem Oder-Glied 10-4 zur Erzeugung eines Taktsignales für eine das Prüfsignal generierende Kippschaltung FF 7-24 zugeführt.

Durch die zuvor beschriebene Schaltung wird für jede Zeitebene die zeitparallel pro Zyklus verfügbare Prüfsignal- Formatinformation ohne Zeitrelation (z.B. die auf Leitung 7-131 für die Zeitebene A anstehende Information gehe auf "1") mit den für diese Zeitebene maßgebenden Zeitgebersignalen (z.B. A-DATA.GEN. in Fig. 3 für die Zeitebene A) zum Prüfsignal verknüpft. So wird z.B. Information "gehe auf "1"" auf Leitung 7-131 vom Und-Glied 10-2A während des Pulses TL C01B des Zeitgebersignales A-DATA.GEN (in Fig. 3) durchgeschaltet. Die Wirkungsweise der Und-Glieder 10-2B, 10-2C im Zusammenwirken mit den Zeitgebersignalen der Zeitebenen B bzw. C erfolgt analog.

Jede Signal-Veränderung am Ausgang Q der Kippschaltung 10-5, die das Prüfsignal führt, mit dem das Produkt (1-2 in Fig. 1) beaufschlagt wird, wird über das Taktsignal am C-Eingang dieser Kippschaltung 10-5 bewirkt. Diese Kippschaltung ist nicht - wie beim bisher bekannten Stand der Technik - mit einem zusätzlichen Rücksetzeingang R beschaltet. Ein solcher zusätzlicher Rücksetzeingang führte wie eingangs beschrieben zu den nachteiligen unterschiedlichen Laufzeiten der Signale in einer solchen Kippschaltung (von R -rücksetzen- nach Q und S -setzen- nach Q).

Der Vorteil der in Fig. 10 beschriebenen Verknüpfungsschaltung liegt darin, daß sich unterschiedliche Laufzeiten der Signale in den Verknüpfungspfaden 10-2A, 10-2B und 10-2C und 10-3 nicht auf das Prüfsignal auf der Leitung 10-6 auswirken können, da dieses nur über den Takteingang C gesteuert wird. Die Zeitgebersignale werden direkt über das Oder-Glied 10-4 auf diesen Takteingang C geleitet, ohne daß Zeit-Kompensationsglieder erforderlich sind, welche wiederum zeitliche Ungenauigkeiten bedingen würden.

In der Schaltung nach Fig. 10 muß folgende Bedingung für eine eindeutige Taktgabe erfüllt sein: Die Signallaufzeit auf dem mit II markierten Weg (über 10-4) darf nicht kürzer sein als die auf dem mit I bezeichneten Weg (über 10-2A, B, C, 10-3).

Andernfalls könnte kein einwandfreies Steuern des für eine bestimmte Zeit am D-Eingang des FF 10-5 anstehenden Datensignales mit der Flanke des Zeitgebersignales am C-Anschluß erfolgen. Das Datensignal steht solange am D-Eingang an, wie es seiner zeitlichen Pulsbreite entspricht. Während dieser Zeit muß die steuernde Flanke des Zeitgebersignales am C-Anschluß des FF 10-5 auftreten, damit ab dem Zeitpunkt des Auftretens dieser Flanke ein Durchschalten des Datensignales auf den Q-Ausgang des FF 10-5 erfolgen kann. Durch den in Fig. 10 mit II über 10-4 führende Weg ist die zeitliche Genauigkeit des auf der Leitung 10-6 geführten Prüfsignales bestimmt.

Aufgrund der Forderung, daß die Signallaufzeit auf Weg II nicht kürzer als auch Weg I sein darf, müßte theoretisch auf Weg II ein zusätzliches Verzögerungsglied vorgesehen werden. Grund: Auf Weg I gibt es zwei eine Verzögerung bedingende Schaltungsteile, z.B. 7-21 und 10-3, auf Weg II nur eines (10-4). Eine solche Lösungsmöglichkeit kann jedoch dadurch umgangen werden, daß bei Verwendung einer positiven Flankentriggerung des FF 7-24 dieses mit dem invertierten Ausgangssignal des Oder-Gliedes 10-4 beaufschlagt wird. Dadurch wird erreicht, daß eine gewollte zusätzliche Verzögerung erreicht wird, deren Wert der Zeitdauer des Zeitgebersignales entspricht.

Bei dieser Lösung ist jedoch zu beachten, daß hierbei die Abfallflanke des Zeitgebersignales die Zeitgenauigkeit des Prüfsignales bestimmt. Um eine hohe Prüfsignal-Testfrequenz auf der Leitung 10-6 vorzusehen, müssen am Eingang des Oder-Gliedes 7-26 kurze Zeitgebersignale verfügbar gemacht werden.

Dies steht im Gegensatz zu der problemloseren Verwendung längerer Zeitgebersignale, was jedoch zu einer unerwünschten zeitlichen Überlappung am Oder-Glied 7-26 führen würde. Zur Vermeidung einer solchen Überlappung kann z.B. in bekannter Weise jedes längere Zeitgebersignal einem Und-Glied zugeführt werden, dessen zweiter Eingang mit dem negierten entsprechend verzögerten Zeitgebersignal beaufschlagt wird.

In Fig. 11 ist ein Blockschaltbild zur Pulsformung der Prüfsignale mehrerer Kanäle dargestellt.

Wie bereits in Zusammenhang mit Fig. 6 beschrieben, sind für die Erzeugung verschiedener Prüfsignale (z.B. ADDRESS, DATAIN, WRITE) verschiedene Kanäle (KANAL 1, 2, 3) vorgesehen. Jeder Kanal besteht aus einem Zeitgeber und einer Formatierungsschaltung.

In Fig. 11 ist für jeden der 3 Kanäle jeweils die Ausgangskippschaltung 6-41, 6-42, 6-43 dargestellt, deren (10-5) Funktion im Zusammenhang mit Fig. 10 beschrieben wurde.

Am Q-Ausgang jeder Kippschaltung erscheint das Prüfsignal. Das an der Kippschaltung 6-41 auftretende Prüfsignal wird einem Pulsformer 11-1, das an der Kippschaltung 6-42 auftretende Prüfsignal wird einem Pulsformer 11-2 und das an der Kippschaltung 6-43 auftretende Prüfsignal wird einem Pulsformer 11-3 zugeführt.

Die Hinweise AC/DC an den Pulsformer sollen andeuten, daß vor dem funktionellen Produkttest mit den Prüfsignalen (AC = Betrieb mit Signalwechseln) eine Strom/Widerstandsprüfung des Produktes mit Gleichstrom (DC) z.B. auf Leckströme u.a.m. erfolgt.

Nach der Pulsformung werden die Prüfsignale dem Produkt zugeführt.

In Fig. 14 ist ein Blockschaltbild zur Funktionsprüfung eines auszutestenden Produktes gezeigt. Das Produkt 6-5 wird unter Berücksichtigung einer wahlweise zuschaltbaren Last 14-4 (z.B. Widerstand, Kapazität, Induktivität etc.) mit dem Prüfsignal beaufschlagt. Die in dieser Fig. 14 gezeigte Schaltung ersetzt den in Fig. 11 gezeigten Pulsformer, sofern es sich bei den Prüfsignalen um Datensignale handelt.

Das auf Leitung 10-6 (Fig. 11) anstehende Prüfsignal wird zunächst einem Treiber 14-1 (Fig. 14) zugeführt.

Er ist mit einer Steuerleitung 14-2 verbunden, über die ihm ein das Signal 3-STATE zugeführt wird. Dieses Signal schaltet den Treiber-Ausgang hochohmig (was z.B. beim Auslesen von Signalen aus dem Produkt erforderlich ist). Das Signal LOAD auf Leitung 14-7 bewirkt, daß der Leitung 14-3, auf der das Produkt 6-5 (Fig. 6) mit dem Prüfsignal beaufschlagt wird, eine Last 14-4 zugeschaltet wird.

Diese Last wird je nach den Umgebungs-Erfordernissen für die Produktprüfung ausgewählt. Für die Prüfung auf in an adressierte Stellen des Produktes eingeschriebene Information, z.B. eine binäre "0" oder binäre "1", sind ein "0" Detektor 14-5 und ein "1" Detektor 14-6 vorgesehen. Diese Detektorschaltungen haben den üblichen Aufbau bekannter sogenannter Analog-Komparatoren.

Ein solcher Komparator stellt über einen auf einer seiner Eingangsleitungen angelegten Referenzwert "1" Ref (Spannung für eine logische "1") oder "0" Ref (Spannung für eine logische "0") fest, ob die vom Produkt auf Leitung 14-3 angeforderte Auslesespannung (von der eingeschriebenen Information her stammend) diesem Referenzwert entspricht oder nicht. Das den Komparator beaufschlagende Strobe "1" bzw. Strobe "0"-Signal dient dazu, zu einer bestimmten Zeit (zu der dieses Strobe-Signal auftritt) nach Beginn des Prüfsignales festzustellen, ob auch wirklich die Auslesespannung der Testvorgabe einer logischen "1" bzw. "0" entspricht.

## Patentansprüche

1. Verfahren zur Erzeugung von produktspezifischen digitalen Prüfsignalen und/oder Steuersignalen
zum Austesten von Digitalspeichern (1-2) oder logischen Schaltungen zur Adressierung, Prüfdaten- und Funktionsvorgabe aus Daten- und Zeitgebersignalen, und/oder zur Erzeugung von digitalen Steuersignalen aus Daten- und Zeitgebersignalen,
wobei die Prüfsignale/Steuersignale einen innerhalb eines Impulsintervalles liegenden Prüfpuls/Steuerpuls enthalten,
wobei die Datensignale in jeweiliger Zuordnung zu den Prüfsignalen/Steuersignalen pro Impulsintervall Angaben zur Adreß-, Prüfdaten-, und/oder Funktions-Steuerpulsgenerierung umfassen,
wobei die Zeitgebersignale pro Impulsintervall in jeweiliger Zuordnung zu den Datensignalen Informationen umfassen, welche Beginn und/oder Ende der Adreß-, Prüfdaten-, Funktions- und Steuerpulsaktivierung im entsprechenden Prüfsignal/Steuersignal kennzeichnen,
wobei für jedes Datensignal zur computergesteuerten Vorgabe von unterschiedlichen Prüfsignalformaten/Steuersignalformaten ein adressierbarer Formatspeicher (7-11) vorgesehen ist,
wobei in an sich bekannter Weise ein bestimmtes Prüfsignalformat/Steuersignalformat den binären Spannungsverlauf eines Prüfsignales/Steuersignales innerhalb eines Impulsintervalles kennzeichnet und
wobei der eigentliche Prüfpuls/Steuerpuls von formatspezifischen benachbarten Signalen gleichen oder unterschiedlichen Pegels begleitet wird, wobei im Formatspeicher (7-11) für jedes Prüfsignalformat/Steuersignalformat digitale Werte zur Kennzeichnung des Prüfsignalverlaufes/Steuersignalverlaufes ohne Zeitbezug gespeichert sind,
wobei der Formatspeicher (7-11) durch das Datensignal und eine vorzugebende Prüfsignalformatkennzeichnung/Steuersignalformatkennzeichnung adressiert wird,
und wobei in Folge dieser Adressierung pro Impulsintervall die digitalen Werte zur Kennzeichnung des Prüfsignalverlaufes/Steuersignalverlaufes zeitparallel auf einer der Anzahl der Pegelwechsel im Prüfsignalverlauf/Steuersignalverlauf entsprechenden Anzahl von Leitungen am Ausgang des Formatspeichers (7-11) ausgelesen werden,
wobei in an sich bekannter Weise aus digital gespeicherten Werten, die den zeitlichen Verlauf der Prüfsignale/Steuersignale kennzeichnen eine der Anzahl der Pegelwechsel entsprechende Anzahl von Zeitgebersignalen erzeugt werden,
und wobei die Zeitgebersignale für jeweils ein Datensignal mit der Formatspeicherausgangsinformation für das diesem Datensignal zugeordnete Prüfsignalformat/Steuersignalformat in der Reihenfolge der Pegelwechsel im Prüfsignalverlauf/Steuersignalverlauf zur Erzeugung des Prüfsignales/Steuersignales über eine durch die Zeitgebersignale taktgesteuerte und mit einer Verknüpfungsschaltung (2-3) verbundene bistabile Kippschaltung (7-24) verknüpft werden, wobei die Verknüpfungsschaltung (2-3) eine der Anzahl der Zeitebenen entsprechende Zahl von Torschaltungen (7-21, 7-22, 7-23) aufweist und jede der Formatspeicherausgangsleitungen mit einer einer Zeitebene zugeordneten Torschaltung (Und-Glied) (7-21, 7-22, 7-23) verbunden ist, deren zweiter Eingang mit einem zeitebenenspezifischen Zeitgebersignal beaufschlagbar ist, und wobei die Ausgänge aller Torschaltungen mit dem Dateneingang (D) der bistabilen Kippschaltung (7-24) verbunden sind, welche von den Zeitgebersignalen aller Zeitebenen getaktet (c) wird und an deren Ausgang (Q) das Prüfsignal abnehmbar ist, so daß die für die Prüfsignal/Steuersignalgenerierung maßgebliche interne Signallaufzeit immer den gleichen Wert aufweist.

2. Verfahren nach Anspruch 1, wobei zur Erzeugung verschiedenartiger in Zeitrelation aufeinander abgestimmter Prüfsignale/Steuersignale, prüfsignal/steuersignal-spezifische Daten- und Zeitgebersignale vorgegeben werden,
wobei die Zeitgebersignale je nach der Anzahl n der Pegelwechsel im Prüfsignal/Steuersignalverlauf in eine dieser Anzahl entsprechenden Zahl n von Zeitebenen aufgeteilt werden, wobei sich die Zeitgebersignale in der n-ten Zeitebene auf den n-ten Pegelwechsel im Prüfsignal/Steuersignalverlauf beziehen.

3. Anordnung zur Erzeugung von produktspezifischen digitalen Prüfsignalen/Steuersignalen zum Austesten von Digitalspeichern (1-2) oder logischen Schaltungen zur Adressierung, Prüfdaten- und Funktionsvorgabe aus Daten- und Zeitgebersignalen, und/oder zur Erzeugung von digitalen Steuersignalen aus Daten- und Zeitgebersignalen, wobei die Prüfsignale/Steuersignale einen innerhalb eines Impulsintervalles liegenden Prüfpuls/Steuerpuls enthalten,
wobei die Datensignale in jeweiliger Zuordnung zu den Prüfsignalen/Steuersignalen pro Impulsintervall Angaben zur Adreß-, Prüfdaten-, Funktions- und/oder Steuerpulsgenerierung umfassen,
wobei die Zeitgebersignale pro Impulsintervall in jeweiliger Zuordnung zu den Datensignalen Informationen umfassen, welche Beginn und/oder Ende der Adreß-, Prüfdaten- und Funktions- und Steuerpulsaktivierung im entsprechenden Prüfsignal/Steuersignal kennzeichnen,
wobei ein adressierbarer Formatspeicher (7-11) vorgesehen ist zur computergesteuerten Vorgabe von unterschiedlichen Prüfsignalformaten/Steuersignalformaten für jedes Datensignal,
wobei in an sich bekannter Weise ein bestimmtes Prüfsignalformat/Steuersignalformat den binären Spannungsverlauf eines Prüfsignales/Steuersignales innerhalb eines Impulsintervalles kennzeichnet und
wobei der eigentliche Prüfpuls/Steuerpuls von formatspezifischen benachbarten Signalen gleichen oder unterschiedlichen Pegels begleitet wird, wobei im Formatspeicher (7-11) für jedes Prüfsignalformat/Steuersignalformat digitale Werte zur Kennzeichnung des Prüfsignalverlaufes/Steuersignalverlaufes ohne Zeitbezug gespeichert sind,
wobei eine Adressierschaltung (8-2-1) für den Formatspeicher (7-11) vorgesehen ist, welcher durch das Datensignal und eine vorzugebende Prüfsignalformatkennzeichnung/Steuersignalformatkennzeichnung adressiert wird,
wobei Schaltungsmittel vorgesehen sind, durch die in Folge der Adressierung des Formatspeichers pro Impulsintervall die digitalen Werte zur Kennzeichnung des Prüfsignalverlaufes/Steuersignalverlaufes zeitparallel auf einer der Anzahl der Pegelwechsel im Prüfsignalverlauf/Steuersignalverlauf entsprechenden Anzahl von Leitungen am Ausgang des Formatspeichers (7-11) auslesbar sind,
wobei Schaltungsmittel (1-9, 1-6) zur an sich bekannten Erzeugung von Zeitgebersignalen aus digital gespeicherten Werten, die den zeitlichen Verlauf der Prüfsignale/Steuersignale kennzeichnen, vorgesehen sind,
und wobei eine Kippschaltung (7-24) vorgesehen ist, welche durch die Zeitgebersignale taktgesteuert wird, und durch welche die Zeitgebersignale für jeweils ein Datensignal mit der Formatspeicherausgangsinformation für das diesem Datensignal zugeordnete Prüfsignalformat/Steuersignalformat in der Reihenfolge der Pegelwechsel im Prüfsignalverlauf/Steuersignalverlauf zur Erzeugung des Prüfsignales/Steuersignales verknüpft werden, wobei die für die Prüfsignalgenerierung/Steuersignalgenerierung maßgebliche interne Signallaufzeit der Kippschaltung (7-24) immer den gleichen Wert aufweist.

4. Anordnung nach Anspruch 3, wobei zur Erzeugung verschiedenartiger in Zeitrelation aufeinander abgestimmter Prüfsignale/Steuersignale, prüfsignalspezifische/steuersignalspezifische Daten- und Zeitgebersignale vorgegeben werden,
wobei die Zeitgebersignale je nach der Anzahl n der Pegelwechsel im prüfsignalverlauf/Steuersignalverlauf in eine dieser Anzahl entsprechenden Zahl n von Zeitebenen aufgeteilt werden, wobei sich die Zeitgebersignale in der n-ten Zeitebene auf den n-ten Pegelwechsel im Prüfsignalverlauf/Steuersignalverlauf beziehen.

5. Anordnung nach Anspruch 3, wobei eine den Formatspeicher (7-11) enthaltende Schaltung (2-1) zur Prüfsignalformaterzeugung/Steuersignalformaterzeugung ohne Zeitrelation vorgesehen ist, welche mit einem Datensignal und einer das Prüfsignalformat/Steuersignalformat kenn zeichnenden Steuerinformation beaufschlagbar ist zur zeitparallelen Erzeugung von binären Signalniveaus auf n Ausgangsleitungen (2-11, 2-12, 2-13), wobei das Signalniveau auf jeder einer Zeitebene entsprechenden Ausgangsleitung jeweils einen der n Pegelwechsel innerhalb eines Impulsintervalles im Prüfsignalverlauf/Steuersignalverlauf darstellt,
wobei diese Schaltung (2-1) mit einer Zeitgeberschaltung (2-2) für das Datensignal verbunden ist,
und wobei eine Verknüpfungsschaltung (2-3) vorgesehen ist, durch welche die Signalniveaus der Ausgangsleitungen 2-11, 2-12, 2-13 und die Zeitgebersignale zum Prüfsignal/Steuersignal verknüpfbar sind.

6. Anordnung nach Anspruch 5, wobei zur Erzeugung von verschiedenen Prüfsignalen/Steuersignalen aus verschiedenen Datensignalen für jedes Datensignal jeweils eine Schaltung (2-1) zur Prüfsignalformaterzeugung/Steuersignalformaterzeugung, eine Zeitgeberschaltung (2-2) und eine Verknüpfungsschaltung (2-3) zur Erzeugung des dem Datensignal und dem Prüfsignalformat/Steuersignalformat zugeordneten Prüfsignal/Steuersignal vorgesehen ist.

7. Anordnung nach Anspruch 5 und 6, wobei die Schaltung (2-1) eine Format-Pre-Decoder-Schaltung 7-12 enthält zur Vorgabe von Korrekturwerten zum Laufzeitunterschiedausgleich von Prüfsignalen/Steuersignalen für die Zeitgebersignalerzeugung und durch welche nur Änderungen im Datensignal-Pegelwechsel in einer Zeitebene von Impulsintervall zu Impulsintervall berücksichtigt werden.

8. Anordnung nach Anspruch 5, wobei die Schaltung (2-1) eine Format-PIPELINE-Schaltung (7-13) zur variablen Zeitverzögerung der Datensignale jeder Zeitebene in Anpassung an die Zeitgebersignale umfaßt, welche ein Umlaufregister (13-0) für das Start-Zeitgebersignal aufweist, dessen n Stufen mit jeweils einem Register (13-1, 13-2, 13-3, 13-4) zur Steuerung der Aufnahme von Datensignalinformation verbunden sind,
wobei die Anzahl der Stufen n des Umlaufregisters (13-0) der Anzahl aufeinanderfolgender Impulsinter valle für zwischenzuspeichernde Datensignalinformation entspricht,
und wobei die Ausgänge der Register (13-1, 13-2, 13-3, 13-4) mit einer Multiplexschaltung (13-5) verbunden sind, welche über ein n-stufiges zeitgebersignalgesteuertes Umlaufregister (13-6) gesteuert wird und nacheinander für jedes Impulsintervall die Datensignalinformation zur Verfügung stellt.

## Claims

1. Method of generating product-specific digital test signals and/or control signals
for testing digital memories (1-2) or logic circuits for addressing and predetermining test data and functions from data and timing signals, and/or for generating digital control signals from data and timing signals,
whereby the test signals/control signals contain a test pulse/control pulse occurring during a pulse interval,
whereby the data signals associated with the respective test signals/control signals contain, in each pulse interval, data for address-, test data- and/or function control pulse generation,
whereby, in each pulse interval, the timing signals contain information associated with the respective data signals which denotes the start and/or end of the address, test data, function and control pulse activation in the respective test signal/control signal,
whereby, for each data signal, an addressable format memory (7-11) is provided for the computer-controlled predetermination of different test signal formats/control signal formats,
whereby, in a manner which is familiar as such, a particular test signal format/control signal format denotes the binary voltage curve of a test signal/control signal during a pulse interval, and
whereby the actual test pulse/control pulse is accompanied by format-specific adjacent signals of the same or a different level, whereby the format memory (7-11) stores digital values marking the test signal curve/control signal curve unrelated to time for each test signal/control signal format,
whereby the format memory (7-11) is addressed by the data signal and a predetermined test signal format identifier/control signal format identifier,
and whereby, as a result of this address operation, the digital values marking the test signal curve/control signal curve are read, time-parallel, for each pulse interval, at the output of the format memory (7-11) on a number of lines corresponding to the number of level changes in the test signal curve/control signal curve,
whereby, in a manner which is familiar as such, a number of timing signals corresponding to the number of level changes are generated from digitally-stored values denoting the time curve of the test signals/control signals,
and whereby the timing signals for each individual data signal are linked with the format memory output information for the test signal format/control signal format assigned to the data signal, in the order of the level changes in the test signal curve/control signal curve, in order to generate the test signal via a flip-flop circuit (7-24) which is clock-controlled by the timing signals and connected to a logic circuit, whereby the logic circuit (2-3) features a number of gates (7-21, 7-22, 7-23) corresponding to the number of time planes, and each of the format memory output lines is connected to a gate (AND element) (7-21, 7-22, 7-23) assigned to a time plane, to the second input of which a time-level-specific timing signal can be applied, and whereby the outputs of all gates are connected to the data input (D) of the flip-flop circuit (7-24), which is clocked by the timing signals of all time planes (c) and at the output of which (Q) the test signal can be read, so that the internal signal delay determining the generation of the test signals/control signals always displays the same value.

2. Process in accordance with claim 1, whereby test-signal-specific/control-signal-specific data and timing signals are predetermined in order to generate different types of test signals/control signals which are time-related to each other,
whereby the timing signals are subdivided into a number n of time planes corresponding to the number n of level changes in the test signal/control signal curve, whereby the timing signals for the nth time plane relate to the nth level change in the test signal/control signal curve.

3. Arrangement for generating product-specific digital test signals/control signals for testing digital memories (1-2) or logic circuits for addressing and predetermining test data and functions from data and timing signals, and/or for generating digital control signals from data and timing signals, whereby the test signals/control signals contain a test pulse/control pulse occurring during a pulse interval,
whereby the data signals associated with the respective test signals/control signals contain, in each pulse interval, data for address-, test data- and/or function control pulse generation,
whereby, in each pulse interval, the timing signals contain information associated with the respective data signals which denotes the start and/or end of the address, test data, function and control pulse activation in the respective test signal/control signal,
whereby, for each data signal, an addressable format memory (7-11) is provided for the computer-controlled predetermination of different test signal formats/control signal formats,
whereby, in a manner which is familiar as such, a particular test signal format/control signal format denotes the binary voltage curve of a test signal/control signal during a pulse interval, and
whereby the actual test pulse/control pulse is accompanied by format-specific adjacent signals of the same or a different level, whereby the format memory (7-11) stores digital values marking the test signal curve/control signal curve unrelated to time for each test signal/control signal format,
whereby an addressing circuit (8-2-1) is provided for the format memory (7-11), which is addressed by the data signal and a pre-determined test signal format identifier/control signal format identifier,
whereby circuit elements are provided via which, as a result of the addressing of the format memory, the digital values marking the test signal curve/control signal curve can be read, time-parallel, for each pulse interval, at the output of the format memory (7-11) on a number of lines corresponding to the number of level changes in the test signal curve/control signal curve,
whereby circuit elements (1-9, 1-6) are provided for the generation, in a manner which is familiar as such, of timing signals from digitally-stored values denoting the time curve of the test signals/control signals,
and whereby a flip-flop circuit (7-24) is provided which is clock-controlled by the timing signals, and by means of which the timing signals for each individual data signal are linked with the format memory output information for the test signal format/control signal format assigned to this data signal in the order of the level changes in the test signal curve/control signal curve in order to generate the test signal/control signal, whereby the internal signal delay of the flip-flop circuit (7-24) determining the generation of the test signals/control signals always displays the same values.

4. Arrangement in accordance with claim 3, whereby test-signal-specific/ control-signal-specific data and timing signals are predetermined in order to generate different types of test signals/control signals which are time-related to each other,
whereby, depending on the number n of level changes in the test signal curve/control signal curve, the timing signals are subdivided into a corresponding number n of time planes, whereby the timing signals of the nth time plane relate to the nth level change in the test signal curve/control signal curve.

5. Arrangement in accordance with claim 3, whereby a circuit (2-1), containing the format memory (7-11), is provided for non-time-related test signal format/control signal format generation, this circuit receiving a data signal and control information identifying the test signal fomat/control signal format for the time- parallel generation of binary signal levels on n output lines (2-11, 2-12, 2-13), whereby the signal level on each output line corresponding to a time plane represents one of the n level changes during a pulse interval in the test signal curve/control signal curve,
whereby this circuit (2-1) is connected to a timer circuit (2-2) for the data signal,
and a logic circuit (2-3) is provided by means of which the signal levels of the output lines 2-11, 2-12, 2-13 can be linked with the timing signals to form the test signal/control signal.

6. Arrangement in accordance with claim 5, whereby, in order to generate different test signals/control signals from different data signals, a circuit (2-1) for test signal format generation/control signal format generation, a timing circuit (2-2) and a logic circuit (203) for generating the test signal/control signal assigned to the data signal and the test signal format/control signal format are provided for each data signal.

7. Arrangement in accordance with claim 5 or 6, whereby the circuit (2-1) contains a format pre-decoder circuit (7-12) for predetermining correction values for compensating delay time differences of test signals/control signals for the generation of timing signals, and which only takes into account changes in the data signal level within a time plane from one pulse interval to another.

8. Arrangement in accordance with claim 5, whereby the circuit (2-1) includes a format pipeline circuit (7-13) for the variable time-delay of the data signals of each time plane, adapted to the timing signals, which features a cyclic register (13-0) for the start timing signal, the n stages of which are each linked with a register (13-1, 13-2, 13-3, 13-4) for controlling the reading of data signal information,
whereby the number of stages n of the cyclic register (13-0) corresponds to the number of consecutive pulse intervals for data signal information which is to be buffered,
and whereby the outputs of the registers (13-1, 13-2, 13-3, 13-4) are connected to a multiplex circuit (13-5) which is controlled by an n-stage timing-signal-controlled cyclic register (13-6) and which successively emits the data signal information for each pulse interval.

## Revendications

1. Procédé de génération de signaux de vérification et/ou de signaux de commande, numériques, spécifiques à un produit
pour tester des mémoires numériques (1-2) ou des circuits logiques, quant à l'adressage, à l'allocation de données de vérification et fonctionnelles à partir de signaux de données et de cadenceur, et/ou pour produire des signaux de commande numériques à partir de signaux de données et de cadenceur,
les signaux d'essai/signaux de commande contenant une impulsion d'essai/une impulsion de commande se trouvant dans les limites d'un intervalle d'impulsion,
les signaux de données comprenant, en une association spécifique par rapport aux signaux de vérification/signaux de commande, par intervalle d'impulsion, des indications concernant la génération d'adresses, de données d'essai et/ou d'impulsions fonctionnelles-de commande,
les signaux de cadenceur comprenant, par intervalle d'impulsion, des informations placées en une association spécifique par rapport aux signaux de données et qui caractérisent le début et/ou la fin de l'activation des données d'adresse, de vérification, des impulsions fonctionnelle et de commande, dans le signal d'essai/signal de commande correspondant,
une mémoire de format (7 à 11) adressable étant prévue pour chaque signal de données, pour assurer une allocation commandée par l'ordinateur de différents formats de signal d'essai/signal de commande,
un format de signal de vérification/format de signal de commande déterminé, caractérisant, de matière connue en soi, l'évolution binaire de tension d'un signal de vérification/signal de commande à l'intérieur d'un intervalle d'impulsion, et l'impulsion de vérification/impulsion de commande proprement dite étant accompagnée par des signaux voisins, spécifiques au format, ayant un niveau identique ou différent, des valeurs numériques, destinées à la caractérisation de l'évolution du signal d'essai/de l'évolution du signal de commande, étant stockées sans référence de temps dans la mémoire de format (7-11), pour chaque format de signal d'essai/format de signal de commande,
la mémoire de format (7 à 11) étant adressée au moyen du signal de données et d'une caractérisation de format de signal de vérification/une caractérisation de format de signal de commande prédéfinie,
et, à la suite de cet adressage, par intervalle d'impulsion, les valeurs numériques destinées à caractériser l'évolution du signal de vérification/l'évolution du signal de commande étant lues, chronologiquement en parallèle, sur un nombre, correspondant au nombre d'alternances de niveaux dans l'évolution du signal de vérification/l'évolution du signal, de lignes, à la sortie de la mémoire de format (7 à 11),
un nombre de signaux de cadenceur correspondant au nombre des alternances de niveaux étant produit, de manière connue en soi, à partir de valeurs stockées numériquement et caractérisant l'évolution temporelle des signaux de vérification/signaux de commande,
les signaux de cadenceur destinés chacun à un signal de données étant combinés avec l'information de sortie de mémoire de format pour format de signal de vérification/format de signal de commande associé à ce signal de données, dans l'ordre de succession de l'alternance de niveaux dans l'évolution de signal de vérification/évolution de signal de commande, pour produire le signal de vérification/signal de commande, la combinaison se faisant par l'intermédiaire d'un circuit à bascule (7 à 24) bistable commandé de façon cadencée par les signaux de cadenceur et relié à un circuit de combinaison (2-3), le circuit de combinaison (2-3) présentant un nombre de circuits-portes (7-21, 7-22, 7-23) correspondant au nombre des plans temporels et chacune des lignes de sortie de mémoire de format étant reliée à un circuit à porte (élément logique ET) (7-21, 7-22, 7-23) associé à un plan temporel, circuit à porte dont la deuxième entrée est exposée à un signal de cadenceur spécifique et un plan temporel et les sorties de tous les circuits à portes étant reliées à l'entrée de données (D) du circuit à bascule (7-24) bistable qui est cadencé (c) par les signaux de cadenceur de tous les plans temporels et le signal de vérification pouvant être prélevé à sa sortie (Q) de manière que le temps de franchissement interne du signal caractéristique pour la génération du signal de vérification/signal de commande présente toujours la même valeur.

2. Procédé selon la revendication 1, des signaux de données et des signaux de cadenceur, spécifiques au signal de vérification/signal de commande, étant alloués pour produire différents types de signaux de vérification/signaux de commande conçus les uns par rapport aux autres concernant leur relation temporelle,
les signaux de cadenceur étant subdivisés selon le nombre n d'alternances niveaux dans l'évolution du signal de vérification/signal de commande, en un nombre n de plans temporels correspondants à ce nombre, les signaux de cadenceur se trouvant dans le nième plan temporel se référant à la nième alternance de niveaux dans l'évolution du signal de vérification/signal de commande.

3. Dispositif de production de signaux de vérification/signaux de commande, numériques, spécifiques à un produit, pour tester des mémoires numériques (1-2) ou des circuits logiques, concernant l'adressage, l'allocation de données de vérification et de fonctions à partir de signaux de données et de signaux de cadenceur, et/ou pour la production de signaux de commande numériques à partir de signaux de données et de signaux de cadenceur, les signaux de vérification/signaux de commande contenant une impulsion de vérification/impulsion de commande se trouvant dans les limites d'un intervalle d'impulsion,
les signaux de données comprenant des indications, placées en association spécifique par rapport aux signaux de vérification/signaux de commande, par intervalle d'impulsion, concernant la génération d'adresses, de données de vérification, de fonctions et/ou d'impulsions de commande,
les signaux de cadenceur comprenant par intervalle d'impulsion, en une association spécifique vis-à-vis des signaux de données, des informations qui caractérisent le début et/ou la fin des données d'adresse, de vérification, et l'activation des fonctions et des impulsions de commande, dans le signal de vérification/signal de commande correspondant,
une mémoire de format (7 à 11) adressable étant prévue pour allouer, sous la commande de l'ordinateur, différents formats de signal de vérification/formats de signal de commande pour chaque signal de données
un format de signal de vérification/format de signal de commande déterminé, caractérisant, de manière connue en soi, l'évolution binaire de tension d'un signal de vérification/signal de commande, dans les limites d'un intervalle d'impulsion, et
l'impulsion de vérification/impulsion de commande proprement dite étant accompagnée par des signaux voisins, spécifiques au format, de niveaux identiques ou différents, des valeurs numériques destinées à caractériser l'évolution du signal de vérification/évolution du signal de commande étant stockées dans la mémoire de format (7-11), sans référence de temps, pour chaque format de signal de vérification/format de signal de commande,
un circuit d'adressage (8-2-1) étant prévu pour la mémoire de format (7-11) qui est adressée par le signal de données et une caractéristique de format de signal de vérification/caractéristique de format de signal de commande à fonction d'allocation,
des moyens de circuit étant prévus, au moyen desquels suite à l'adressage de la mémoire de format, par intervalle d'impulsion, les valeurs numériques destinées à la caractérisation de l'évolution du signal de vérification/évolution du signal de commande pouvant être lues temporellement parallèlement sur un nombre de lignes, à la sortie de la mémoire de format (7 à 11), qui correspond au nombre d'alternances de niveaux dans l'évolution du signal de vérification/évolution du signal de commande,
des moyens de circuit (1-9, 1-6) étant prévus pour produire, de manière connue en soi, des signaux de cadenceur à partir de valeurs numériques stockées qui caractérisent l'évolution temporelle du signal de vérification/signal de commande,
et étant prévu un circuit à bascule (7-24), soumis à une commande de cadencement au moyen des signaux de cadenceur et au moyen duquel les signaux de cadenceur destinés à un signal de données respectif sont combinés avec une information de sortie de mémoire de format pour le format de signal de vérification/format de signal de commande associé à ce signal de données, dans l'ordre de succession des alternances de niveaux dans l'évolution du signal de vérification/évolution du signal de commande, pour produire le signal de vérification/signal de commande, le temps de passage interne du signal du circuit à bascule (7-24), qui est spécifique à la génération du signal de vérification/génération du signal de commande, présentant toujours la même valeur.

4. Dispositif selon la revendication 3, des signaux de données et des signaux de cadenceur spécifiques au signal de vérification/spécifiques au signal de commande étant prévus pour produire différents types de signaux de vérification/signaux de commande conçus les uns par rapport aux autres quant à leur relation temporelle
les signaux de cadenceur étant subdivisés selon le nombre n des alternances de niveaux dans l'évolution du signal de vérification/évolution du signal de commande, en un nombre n, correspondant à ce premier nombre, de plans temporels, les signaux de cadenceur se trouvant dans le nième plan temporel se référant à la nième alternance de niveaux dans l'évolution de signal de vérification/évolution de signal de commande.

5. Dispositif selon la revendication 3, un circuit (2-1) contenant une mémoire de format (7-11) étant prévu pour la génération de format de signal de vérification/génération de format de signal de commande, sans relation temporelle, en pouvant être alimenté par un signal de données et une information de commande caractérisant le format de signal de vérification/le format de signal de commande, en vue de générer temporellement parallèlement des niveaux de signaux binaires sur n lignes de sortie (2-11, 2-12, 2-13), le niveau de signal sur chaque ligne de sortie correspondant à un plan temporel constituant respectivement l'une des n alternances de niveaux dans les limites d'un intervalle d'impulsion dans l'évolution du signal de vérification/évolution du signal de commande,
ce circuit (2-1) étant relié à un circuit cadenceur (2-2) pour le signal de données,
et un circuit de combinaison (2-3) étant prévu, au moyen duquel les niveaux de signaux des lignes de sortie (2-11, 2-12, 2-13) et des signaux de cadenceur concernant le signal de vérification/signal de commande peuvent être combinés.

6. Dispositif selon la revendication 5, dans lequel sont respectivement prévus un circuit (2-1) destiné à générer un format de signal de vérification/générer un format de signal de commande, un circuit cadenceur (2-2) et un circuit de combinaison (2-3) destiné à produire le signal de vérification/signal de commande associé au signal de données et au format de signal de vérification/format de signal de commande, pour générer différents signaux de vérification/signaux de commande à partir de différents signaux de données, pour chaque signal de données.

7. Dispositif selon les revendications 5 et 6, le circuit (2-1) contenant un circuit pré-décodeur de format (7-12) destiné à l'allocation de valeurs de correction pour la compensation de différence de temps de passage des signaux de vérification/signaux de commande pour la génération de signaux de cadenceur et circuit au moyen duquel ne sont pris en compte que les variations dans l'alternance de niveaux du signal de données, dans un plan temporel d'un intervalle d'impulsion à un autre intervalle d'impulsion.

8. Dispositif selon la revendication 5, le circuit (2-1) comprenant un circuit-PIPELINE de Format, destiné à opérer un retard temporel variable des signaux de données de chaque plan temporel en adaptation aux signaux de cadenceur, ce circuit comprenant un registre circulant (13-0) pour le signal de cadenceur de début, dont les n étages sont reliés respectivement à un registre (13-1, 13-2, 13-3, 13-4) pour la commande de l'enregistrement de l'information de signal de données,
le nombre d'étages n du registre circulant (13-0) correspondant au nombre d'intervalles d'impulsions successifs pour une information de signal de données devant être l'objet d'un stockage intermédiaire,
et les sorties des registres (13-1, 13-2, 13-3, 13-4) étant reliées à un circuit de multiplexage (13-5) qui est commandé par l'intermédiaire d'un registre circulant à n étages (13-6) commandé par un signal de cadenceur et mettant à disposition l'information de signal de données pour chaque intervalle d'impulsion les uns après les autres.
